Europäisches Patentamt

European Patent Office

Office européen des brevets

(19)

(11) **EP 1 547 719 A2**

(12) **EUROPEAN PATENT APPLICATION**

(43) Date of publication:
**29.06.2005 Bulletin 2005/26**

(51) Int Cl.[7]: **B23K 26/06**, B23K 26/08,
H01L 21/20

(21) Application number: **04030056.8**

(22) Date of filing: **17.12.2004**

(84) Designated Contracting States:
**AT BE BG CH CY CZ DE DK EE ES FI FR GB GR
HU IE IS IT LI LT LU MC NL PL PT RO SE SI SK TR**
Designated Extension States:
**AL BA HR LV MK YU**

(30) Priority: **26.12.2003 JP 2003433357**

(71) Applicant: **SEMICONDUCTOR ENERGY
LABORATORY CO., LTD.
Atsugi-shi Kanagawa-ken 243-0036 (JP)**

(72) Inventor: **Tanaka, Koichiro
Semiconductor Energy Lab. Co. Ltd
Atsugi-shi Kanagawa-ken 243-0036 (JP)**

(74) Representative: **Grünecker, Kinkeldey,
Stockmair & Schwanhäusser Anwaltssozietät
Maximilianstrasse 58
80538 München (DE)**

(54) **Laser irradiation apparatus, laser irradiation method, and method for manufacturing crystalline semiconductor film**

(57) It is an object of the present invention to provide a compact laser irradiation apparatus and a laser irradiation method that use a galvanometer mirror and an fθ lens, that suppress the interference caused by a secondary beam reflected on the rear surface of the substrate, that can perform homogeneous laser annealing to the irradiated object, and that increase throughput. In the present invention, the laser beam has a pulse width t that satisfies an inequality ct<2nd where c is a speed of light in vacuum, n is the refractive index of a substrate with the processing object formed thereon, and d is the thickness of the substrate. With the above structure, even when the galvanometer mirror and the fθ lens are used, it is possible to decrease the effect of the interference due to the secondary beam reflected on the rear surface of the substrate and to perform homogeneous laser annealing to the processing object.

FIG. 1

Printed by Jouve, 75001 PARIS (FR)

EP 1 547 719 A2

## Description

### BACKGROUND OF THE INVENTION

#### 1. Field of the Invention

The present invention relates to a laser irradiation apparatus, a laser irradiation method, and a method for manufacturing a crystalline semiconductor film. The present invention particularly relates to a laser irradiation apparatus, a laser irradiation method, and a method for manufacturing a crystalline semiconductor film that use an optical system including a galvanometer mirror and an fθ lens.

#### 2. Related Art

Some laser irradiation apparatus include an optical system in which the galvanometer mirror and the fθ lens are used as one means for scanning a laser beam emitted from a laser oscillator on an irradiated object.

When the galvanometer mirror is vibrated, an incidence angle of the laser beam into the galvanometer mirror can be changed, and the position irradiated with the laser beam reflected by the galvanometer mirror can be moved. With one galvanometer mirror, it is possible to scan the laser beam in one direction. When the galvanometer mirror scans the laser beam in an X direction and a robot provided to a stage scans the laser beam in a Y direction, the laser irradiation can be performed to the whole surface of the substrate. Moreover, when two galvanometer mirrors are used to scan the laser beam in both X and Y directions, any point on the substrate can be irradiated with the laser beam. (For example, refer to patent document 1)

[Patent document 1] Japanese Patent Laid-Open No. 2003-86507

However, when the galvanometer mirror and the fθ lens are used to perform the laser irradiation to the irradiated object formed over the substrate, the irradiation intensity is different according to the location on the irradiated object even though the laser irradiation is performed under the same condition.

For example, when a semiconductor film formed over a glass substrate is crystallized by the laser irradiation using an optical system including the galvanometer mirror and the fθ lens, the crystallinity varies to such a degree that the variation becomes visible. This is because the semiconductor film is not irradiated homogeneously with the laser beam. When semiconductor elements are formed using the semiconductor film having inhomogeneous crystallinity, their characteristics differ respectively in one substrate.

### SUMMARY OF THE INVENTION

Consequently, in view of the above problem, it is an object of the present invention to provide a laser irradiation apparatus, a laser irradiation method, and a method for manufacturing a crystalline semiconductor film that use an optical system including a galvanometer mirror and an fθ lens and that can give the laser energy homogeneously to the irradiated object.

The present invention discloses a laser irradiation apparatus including a laser oscillator, at least one mirror for deflecting a laser beam emitted from the laser oscillator in one direction, and a lens for having the laser beam deflected by the mirror form an image on a predetermined plane, wherein a pulse width t of the laser beam emitted from the laser oscillator satisfies an inequality ct<2nd where d is a distance between a focal point of the lens and a stage for mounting an irradiated object thereon, n is 1.5, and c is a speed of light in vacuum.

The present invention discloses a laser irradiation apparatus including a laser oscillator, at least one mirror for deflecting a laser beam emitted from the laser oscillator in one direction, and a lens for having the laser beam deflected by the mirror form an image on a predetermined plane, wherein a pulse width t of the laser beam emitted from the laser oscillator satisfies an inequality ct<4nd where d is a distance between a focal point of the lens and a stage for mounting an irradiated object thereon, n is 1.5, and c is a speed of light in vacuum.

The present invention discloses a laser irradiation apparatus including a laser oscillator, at least one galvanometer mirror, and an fθ lens, wherein a pulse width t of a laser beam emitted from the laser oscillator satisfies an inequality ct<2nd where d is a distance between a focal point of the lens and a stage for mounting an irradiated object thereon, n is 1.5, and c is a speed of light in vacuum.

The present invention discloses a laser irradiation apparatus including a laser oscillator, at least one galvanometer mirror, and an fθ lens, wherein a pulse width t of a laser beam emitted from the laser oscillator satisfies an inequality ct<4nd where d is a distance between a focal point of the lens and a stage for mounting an irradiated object thereon, n is 1.5, and c is a speed of light in vacuum.

The present invention discloses a laser irradiation apparatus including a laser oscillator, a first mirror for scanning a beam spot of a laser beam emitted from the laser oscillator on an irradiated object in a first direction, a second mirror for scanning the beam spot of the laser beam emitted from the laser oscillator on the irradiated object in a second direction perpendicular to the first direction, and an fθ lens for having the laser beam form an image on the irradiated object, wherein a pulse width t of the laser beam satisfies an inequality ct<2nd where d is a distance between a focal point of the lens and a stage for mounting the irradiated object thereon, n is 1.5, and c is a speed of light in vacuum.

The present invention discloses a laser irradiation apparatus including a laser oscillator, a first mirror for scanning a beam spot of a laser beam emitted from the laser oscillator on an irradiated object in a first direction, a second mirror for scanning the beam spot of the laser beam emitted from the laser oscillator on the irradiated object in a second direction perpendicular to the first direction, and an fθ lens for having the laser beam form an image on the irradiated object, wherein a pulse width t of the laser beam satisfies an inequality ct<4nd where d is a distance between a focal point of the lens and a stage for mounting the irradiated object thereon, n is 1.5, and c is a speed of light in vacuum.

The present invention discloses a laser irradiation apparatus including a laser oscillator, a mirror for scanning a beam spot of a laser beam emitted from the laser oscillator on an irradiated object in a first direction, a stage for mounting the irradiated object thereon and for moving in a second direction perpendicular to the first direction, and an fθ lens for having the laser beam form an image on the irradiated object, wherein a pulse width t of the laser beam satisfies an inequality ct<2nd where d is a distance between a focal point of the lens and the stage for mounting the irradiated object thereon, n is 1.5, and c is a speed of light in vacuum.

The present invention discloses a laser irradiation apparatus including a laser oscillator, a mirror for scanning a beam spot of a laser beam emitted from the laser oscillator on an irradiated object in a first direction, a stage for mounting the irradiated object thereon and for moving in a second direction perpendicular to the first direction, and an fθ lens for having the laser beam form an image on the irradiated object, wherein a pulse width t of the laser beam satisfies an inequality ct<4nd where d is a distance between a focal point of the lens and the stage for mounting the irradiated object thereon, n is 1.5, and c is a speed of light in vacuum.

The present invention discloses a laser irradiation method in which a semiconductor film formed over a substrate having a thickness d and a refractive index n is irradiated with a laser beam whose pulse width t satisfies an inequality ct<2nd where c is a speed of light in vacuum using an optical system including at least one galvanometer mirror and an fθ lens.

The present invention discloses a laser irradiation method in which a semiconductor film formed over a substrate having a thickness d and a refractive index n is irradiated with a laser beam whose pulse width t satisfies an inequality ct<4nd where c is a speed of light in vacuum using an optical system including at least one galvanometer mirror and an fθ lens.

The present invention discloses a laser irradiation method including the step of irradiating a semiconductor film formed over a substrate with a laser beam in such a way that the laser beam is scanned on the semiconductor film by at least one galvanometer mirror and an fθ lens, wherein one point in the semiconductor film is irradiated simultaneously with both the laser beam incident into the semiconductor film and the laser beam reflected on a rear surface of the substrate for a time corresponding to 10% or less of a pulse width of the laser beam.

The present invention discloses a laser irradiation method including the step of irradiating a semiconductor film formed over a substrate having a thickness d and a refractive index n with a laser beam having a pulse width t that satisfies an inequality ct<2nd where c is a speed of light in vacuum, wherein the laser beam is scanned on the semiconductor film in a first direction by a first galvanometer mirror, wherein the laser beam is scanned on the semiconductor film in a second direction perpendicular to the first direction by a second galvanometer mirror, and wherein the laser beam forms an image on the semiconductor film by an fθ lens.

The present invention discloses a laser irradiation method including the step of irradiating a semiconductor film formed over a substrate having a thickness d and a refractive index n with a laser beam having a pulse width t that satisfies an inequality ct<4nd where c is a speed of light in vacuum, wherein the laser beam is scanned on the semiconductor film in a first direction by a first galvanometer mirror, wherein the laser beam is scanned on the semiconductor film in a second direction perpendicular to the first direction by a second galvanometer mirror, and wherein the laser beam forms an image on the semiconductor film by an fθ lens.

The present invention discloses a laser irradiation method including the step of irradiating a semiconductor film formed over a substrate with a laser beam in such a way that one point in the semiconductor film is irradiated simultaneously with both the laser beam incident into the semiconductor film and the laser beam reflected on a rear surface of the substrate for a time corresponding to 10% or less of a pulse width of the laser beam, wherein the laser beam is scanned on the semiconductor film in a first direction by a first galvanometer mirror, wherein the laser beam is scanned on the semiconductor film in a second direction perpendicular to the first direction by a second galvanometer mirror, and wherein the laser beam forms an image on the semiconductor film by an fθ lens.

The present invention discloses a laser irradiation method including the step of irradiating a semiconductor film formed over a substrate having a thickness d and a refractive index n with a laser beam having a pulse width t that satisfies an inequality ct<2nd where c is a speed of light in vacuum, wherein the laser beam is scanned on the semiconductor film in a first direction by a galvanometer mirror, wherein the laser beam is scanned on the semiconductor film in a second direction perpendicular to the first direction by moving a stage with the substrate mounted thereon, and wherein the laser beam forms an image on the semiconductor film by an fθ lens.

The present invention discloses a laser irradiation method including the step of irradiating a semiconductor film formed over a substrate having a thickness d and a refractive index n with a laser beam having a pulse width t that satisfies an inequality ct<4nd where c is a speed of light in vacuum, wherein the laser beam is scanned on the semiconductor film in a first direction by a galvanometer mirror, wherein the laser beam is scanned on the semiconductor film in a second direction perpendicular to the first direction by moving a stage with the substrate mounted thereon, and wherein the laser beam forms an image on the semiconductor film by an fθ lens.

The present invention discloses a laser irradiation method including the step of irradiating a semiconductor film formed over a substrate with a laser beam in such a way that one point in the semiconductor film is irradiated simultaneously with both the laser beam incident into the semiconductor film and the laser beam reflected on a rear surface of the substrate for a time corresponding to 10% or less of a pulse width of the laser beam, wherein the laser beam is scanned on the semiconductor film in a first direction by a galvanometer mirror, wherein the laser beam is scanned on the semiconductor film in a second direction perpendicular to the first direction by moving a stage with the substrate mounted thereon, and wherein the laser beam forms an image on the semiconductor film by an fθ lens.

The present invention discloses a method for manufacturing a crystalline semiconductor film including the steps of forming an amorphous semiconductor film over a substrate having a refractive index n and a thickness d, and irradiating the amorphous semiconductor film with a laser beam having a pulse width t that satisfies an inequality ct<2nd where c is a speed of light in vacuum using an optical system including at least one galvanometer mirror and an fθ lens.

The present invention discloses a method for manufacturing a crystalline semiconductor film including the steps of forming an amorphous semiconductor film over a substrate having a refractive index n and a thickness d, and irradiating the amorphous semiconductor film with a laser beam having a pulse width t that satisfies an inequality ct<4nd where c is a speed of light in vacuum using an optical system including at least one galvanometer mirror and an fθ lens.

The present invention discloses a method for manufacturing a crystalline semiconductor film including the steps of forming an amorphous semiconductor film over a substrate and irradiating the amorphous semiconductor film with a laser beam in such a way that the laser beam is scanned on the amorphous semiconductor film by at least one galvanometer mirror and an fθ lens, wherein one point in the amorphous semiconductor film is irradiated simultaneously with both the laser beam incident into the amorphous semiconductor film and the laser beam reflected on a rear surface of the substrate for a time corresponding to 10% or less of a pulse width of the laser beam.

The present invention discloses a method for manufacturing a crystalline semiconductor film including the steps of forming an amorphous semiconductor film over a substrate having a thickness d and a refractive index n and irradiating the amorphous semiconductor film with a laser beam having a pulse width t that satisfies an inequality ct<2nd where c is a speed of light in vacuum, wherein the laser beam is scanned on the amorphous semiconductor film in a first direction by a first galvanometer mirror, wherein the laser beam is scanned on the amorphous semiconductor film in a second direction perpendicular to the first direction by a second galvanometer mirror, and wherein the laser beam forms an image on the amorphous semiconductor film by an fθ lens.

The present invention discloses a method for manufacturing a crystalline semiconductor film including the steps of forming an amorphous semiconductor film over a substrate having a thickness d and a refractive index n and irradiating the amorphous semiconductor film with a laser beam having a pulse width t that satisfies an inequality ct<4nd where c is a speed of light in vacuum, wherein the laser beam is scanned on the amorphous semiconductor film in a first direction by a first galvanometer mirror, wherein the laser beam is scanned on the amorphous semiconductor film in a second direction perpendicular to the first direction by a second galvanometer mirror, and wherein the laser beam forms an image on the amorphous semiconductor film by an fθ lens.

The present invention discloses a method for manufacturing a crystalline semiconductor film including the steps of forming an amorphous semiconductor film over a substrate and irradiating the amorphous semiconductor film with a laser beam in such a way that one point in the amorphous semiconductor film is irradiated simultaneously with both the laser beam incident into the amorphous semiconductor film and the laser beam reflected on a rear surface of the substrate for a time corresponding to 10% or less of a pulse width of the laser beam, wherein the laser beam is scanned on the amorphous semiconductor film in a first direction by a first galvanometer mirror, wherein the laser beam is scanned on the amorphous semiconductor film in a second direction perpendicular to the first direction by a second galvanometer mirror, and wherein the laser beam forms an image on the amorphous semiconductor film by an fθ lens.

The present invention discloses a method for manufacturing a crystalline semiconductor film including the steps of forming an amorphous semiconductor film over a substrate having a thickness d and a refractive index n and irradiating the amorphous semiconductor film with a laser beam having a pulse width t that satisfies an inequality ct<2nd where c is a speed of light in vacuum, wherein the laser beam is scanned on the amorphous semiconductor film in a first direction by a galvanometer mirror, wherein the laser beam is scanned on the amorphous semiconductor film in a second direction perpendicular to the first direction by moving a stage with the substrate mounted thereon, and wherein the laser beam forms an image on the amorphous semiconductor film by an fθ lens.

The present invention discloses a method for manufacturing a crystalline semiconductor film including the steps of forming an amorphous semiconductor film over a substrate having a thickness d and a refractive index n and irradiating the amorphous semiconductor film with a laser beam having a pulse width t that satisfies an inequality ct<4nd where c is a speed of light in vacuum, wherein the laser beam is scanned on the amorphous semiconductor film in a first direction by a galvanometer mirror, wherein the laser beam is scanned on the amorphous semiconductor film in a second direction perpendicular to the first direction by moving a stage with the substrate mounted thereon, and wherein the laser beam forms an image on the amorphous semiconductor film by an fθ lens.

The present invention discloses a method for manufacturing a crystalline semiconductor film including the steps of forming an amorphous semiconductor film over a substrate and irradiating the amorphous semiconductor film with a laser beam in such a way that one point in the amorphous semiconductor film is irradiated simultaneously with both the laser beam incident into the amorphous semiconductor film and the laser beam reflected on a rear surface of the substrate for a time corresponding to 10% or less of a pulse width of the laser beam, wherein the laser beam is scanned on the amorphous semiconductor film in a first direction by a galvanometer mirror, wherein the laser beam is scanned on the amorphous semiconductor film in a second direction perpendicular to the first direction by moving a stage with the substrate mounted thereon, and wherein the laser beam forms an image on the amorphous semiconductor film by an fθ lens.

It is noted that the method for manufacturing a crystalline semiconductor film of the present invention can be applied to manufacture an integrated circuit and a semiconductor display device. As the semiconductor display device, there are a liquid crystal display device, a light-emitting display device with a light-emitting element typified by an organic light-emitting element equipped in each pixel, a DMD (Digital Micromirror Device), a PDP (Plasma Display Panel), an FED (Field Emission Display), and the like.

Even when the optical system including the galvanometer mirror and the fθ lens is used, the irradiation intensity of the laser beam on the irradiated object can be homogenized by using the laser irradiation apparatus and the laser irradiation method of the present invention. This makes it possible to perform the crystallization and annealing homogeneously to the irradiated object and to reduce the variation of the characteristic between the semiconductor elements manufactured using the irradiated object. It is noted that the laser beam emitted from the laser oscillator may be incident vertically or obliquely into the irradiated object.

Moreover, since the galvanometer mirror and the fθ lens occupy a small area and provide high throughput, the production efficiency can be increased and the space can be saved while performing the homogeneous laser irradiation.

BRIEF DESCRIPTION OF THE DRAWINGS

FIG. 1 is a drawing of a laser irradiation apparatus of the present invention.
FIG. 2 is a drawing for showing a scanning route of the laser beam.
FIG. 3 is a drawing of a laser irradiation apparatus of the present invention.
FIG. 4 is a drawing for showing the selective irradiation.
FIGS. 5A to 5D are drawings for showing a manufacturing process of a semiconductor device according to the present invention.
FIGS. 6A and 6B are drawings for showing a manufacturing process of a semiconductor device according to the present invention.
FIG. 7A is a drawing of a bottom-emission light-emitting display device,
FIG. 7B is a drawing of a dual-emission light-emitting display device, and
FIG. 7C is a drawing of a top-emission light-emitting display device.
FIGS. 8A to 8 F are drawings for showing electronic devices to which the present invention can be applied.
FIGS. 9A to 9C are drawings for showing electronic devices to which the present invention can be applied.

DETAILED DESCRIPTION OF THE INVENTION

An embodiment mode and embodiments of the present invention are hereinafter explained. However, since the present invention can be embodied in many different modes, it is easily understood by those skilled in the art that the modes and the details of the present invention can be changed and modified in various ways unless such changes and modifications depart from the scope and the content of the present invention hereinafter defined. Thus, the present invention is not limited to the description of the embodiment mode and the embodiments.

[Embodiment Mode]

This embodiment mode explains a laser irradiation apparatus for performing laser irradiation to an irradiated object provided or manufactured over a substrate in such a way that a laser beam having an ultrashort pulse width, which is an order of picosecond ($10^{-12}$ second) or less, is scanned by an optical system including a galvanometer mirror and an fθ lens.

By using the laser irradiation apparatus having this structure, the irradiation intensity of the laser beam can be homogenized on the irradiated object. Moreover, since the galvanometer mirror and the fθ lens occupy a small area and provide high throughput, the throughput can be increased and the space can be saved while performing the homogeneous laser irradiation.

The reason why the problem described above can be solved by the above structure is as follows.

The present inventor considers that the inhomogeneous laser irradiation performed using the optical system including the galvanometer mirror and the fθ lens is caused by the interference between the laser beam (a primary beam) irradiated directly to the irradiated object and the laser beam (a secondary beam) incident into the irradiated object again after reflecting on a rear surface of the substrate. Moreover, the interference occurs due to the distortion and the convexoconcave of the substrate.

When the laser beam, which is an electromagnetic wave having a certain wavelength, is irradiated to the irradiated object, the laser beam is absorbed in the irradiated object and the heat is generated in the part that is irradiated with the laser beam. The laser annealing is performed using this heat. It is noted that a material has its own absorption coefficient. When an electromagnetic wave having a certain wavelength is irradiated to the material that is comparatively thin and that has comparatively low absorption coefficient, the laser beam not absorbed in the irradiated object may transmit through the irradiated object.

For example, in the case where an amorphous silicon film formed over a glass substrate is irradiated with a second harmonic (wavelength 532 nm) of a Nd: YAG laser, most of the laser beam is absorbed in the amorphous silicon film when the film thickness of the amorphous silicon film is 200 nm or more. However, when the film thickness is less than 200 nm, the laser beam not absorbed in the amorphous silicon film transmits therethrough. A part of the transmitted laser beam is reflected on a front surface of the glass substrate, and another part of the laser beam is reflected on a rear surface of the glass substrate and is incident into the amorphous silicon film again. When the glass substrate has minute distortion or convexoconcave, the angle of the secondary beam reflected on the part having the distortion or the convexoconcave is changed. As a result, the optical length of the secondary beam from the rear surface of the glass substrate to the front surface of the glass substrate changes in accordance with the changed angle. When the secondary beam interferes with the primary beam that is irradiated directly, a region where the beams always intensify each other and a region where the beams are always attenuated each other are formed. In other words, standing wave is formed on the silicon film and this distribution is recorded on the silicon film.

At present, a glass substrate used as the substrate in the thin film semiconductor device such as a flat panel display has a thickness of approximately 1000 μm, and a glass substrate having a thickness of approximately 700 μm is often used. The thickness of 700 μm is 1000 times or more greater than the wavelength of the laser beam (herein 532 nm). It is very difficult to control the thickness of the substrate at the accuracy of 1/1000 of the thickness of the substrate, and it is obvious that the minute distortion and the minute convexoconcave described above exist.

Consequently, in the present invention, a pulse width is set to an order of picosecond ($10^{-12}$ second) or less so that the time for which a primary beam exists simultaneously with a secondary beam reflected on the rear surface of the substrate in the irradiated object is short or so that the primary beam and the secondary beam don't exist simultaneously in the irradiated object. With this structure, the ratio of the time for which the interference occurs with respect to the time for which the laser is irradiated to the irradiated surface is decreased so that the effect due to the interference is suppressed or is zero so that the interference does not occur.

The principle of the present invention is explained simply as showing an example to which the present invention can be applied. Since the laser beam is an electromagnetic wave, it is considered that the speed of the laser beam is the same as that of the light (approximately 300,000 km/s). When the pulse width is set to 10 ps as shown in the present invention, the beam travels approximately 3 mm after the pulsed laser beam starts to be emitted until the emission is completed (approximately 10 ps). In other words, the laser beam can be regarded to have a travel distance of approximately 3 mm for one pulse.

When a laser beam having a travel distance of 3 mm for one pulse and a pulse width of 10 ps is irradiated to the irradiated object formed over a substrate having a thickness of approximately 700 μm, the time for which the interference occurs between the primary beam irradiated directly and the secondary beam reflected from the rear surface of the substrate is approximately 50% of the irradiation time. Moreover, when the pulse width is set to as short as approximately 5 ps, the interference can be avoided perfectly. Since this can suppress the interference due to the reflection of the laser beam transmitted through the irradiated object, it is possible to perform the laser irradiation homogeneously and to homogenize the irradiation intensity of the laser beam on the irradiated surface even when the optical system including the galvanometer mirror and the fθ lens is used to scan the laser beam. Since the laser irradiation apparatus using the galvanometer mirror and the fθ lens occupies a small area and provides high throughput, the production efficiency can be improved while saving the space.

On the other hand, the laser beam used in the conventional laser annealing has a pulse width from several tens to several hundred ns. Therefore, the laser beam travels 3 to 100 m while one pulsed laser beam is emitted. In other words, the laser beam can be regarded to have the travel distance from 3 to 100 m for one pulse.

When the laser beam having a travel distance of approximately 3 m and a pulse width of 10 ns is used to irradiate the irradiated object formed over a substrate having a thickness of approximately 700 μm, it can be said from the calculation that the interference occurs in the irradiated object for 99.5% of the net irradiation time. In other words, when the pulse width is changed from 10 ns to 10 ps, the irradiation inhomogeneity due to the interference can be reduced to be approximately a half according to the calculation. When the pulse width is 5 ps, the interference due to the above structure does not occur according to the calculation.

The above explanation was made on the broad concept of the present invention, and the further explanation is hereinafter made more specifically. When the light travels in a certain medium, the refractive index of the medium affects the speed of the light. For example, when the light traveling in the air having a refractive index of 1 is incident into a glass having a refractive index of 1.5, the speed of light becomes 1/1.5. In consideration of this fact, in order that the secondary beam reflected on the rear surface of the substrate having a refractive index n and a thickness d does not cause the interference, the pulse width t may satisfy the inequality 1 below where c is the speed of light in vacuum. It is noted that the focal point is always on the irradiated object and that the thickness d of the substrate roughly corresponds to the distance between the focal point and a stage for mounting the irradiated object thereon.

$$ct < 2nd \qquad \text{(inequality 1)}$$

According to the inequality 1, it is understood that when an amorphous silicon film formed over a glass substrate having a thickness d of 0.7 mm and a refractive index n of 1.5 is crystallized, a pulse width t that does not cause the interference at all is approximately 7 ps or less. It is noted that the speed of light in vacuum is 300,000 km/s in the calculation.

Even though the galvanometer mirror and the fθ lens are used to scan the laser beam on the irradiated object, the laser irradiation by the laser beam having the pulse width that satisfies the inequality 1 makes it possible to prevent the interference due to the reflection from the rear surface of the substrate and to homogenize the irradiation energy on the irradiated surface. Since the laser irradiation apparatus including the galvanometer mirror and the fθ lens occupies a small area and provides high throughput, the production efficiency can be improved while saving the space.

In the case where the amorphous semiconductor film is crystallized by the laser irradiation to form a poly-crystalline semiconductor film, when the power of the laser beam fluctuates widely, the crystallization is not performed homogeneously. Therefore, when TFTs are manufactured using the poly-crystalline semiconductor film obtained thus as an active layer, the characteristic such as on-current or mobility varies between the TFTs. Since the laser beam fluctuates temporally for ±1% even though the laser beam does not interfere, it is considered that the spatial light and shade of the luminance due to the interference can be prevented from being visible in the pixel portion by suppressing the interference to such a degree that the spatial fluctuation of the power becomes less than ± 1% when forming the TFT used for the pixel portion of the semiconductor display device.

On the other hand, in the case of irradiating an amorphous semiconductor film formed over a glass substrate with a laser beam having a second harmonic, it is considered that a half of the laser beam is reflected on a front surface of the amorphous semiconductor film and that the other half thereof goes into the amorphous semiconductor film. Since the semiconductor film used as an active layer of the TFT in the semiconductor display device has a thickness of approximately several tens nm, it is considered that a half of the laser beam among the laser beam going into the amorphous semiconductor film is absorbed in the amorphous semiconductor film and that the other half thereof goes into the glass substrate in consideration of the absorption coefficient of the amorphous semiconductor film. Then, 4% of the laser beam going into the glass substrate is reflected on a rear surface of the glass substrate and goes into the amorphous semiconductor film again. Therefore, the ratio of the light returned to the amorphous semiconductor film after reflecting on the rear surface of the glass substrate with respect to the light incident into the amorphous semiconductor film from the laser oscillator is approximately 2%. When these light interfere, the power fluctuates for ±2%.

Therefore, in order to suppress the interference to such a degree that spatial fluctuation of the power is less than ±1%, the time for which the light interfere is preferably made shorter than a half of the pulse width t. It is more preferable that the time for which one point in the amorphous semiconductor film is irradiated simultaneously with the two laser beams is 10% or less of the pulse width. In the case of making the time for which the two laser beams interfere shorter than a half of the pulse width t, it is understood from the inequality 1 that the pulse width t of the laser beam may satisfy an inequality 2.

$$ct < 4nd \qquad \text{(inequality 2)}$$

The proper pulse width t of the laser beam changes according to the circumstances. When the time for which the laser beams interfere is X[%] or less of the pulse width, the pulse width t may satisfy an inequality 3.

$$ct(100-X)/100 < 2nd \qquad \text{(inequality 3)}$$

[Embodiment 1]

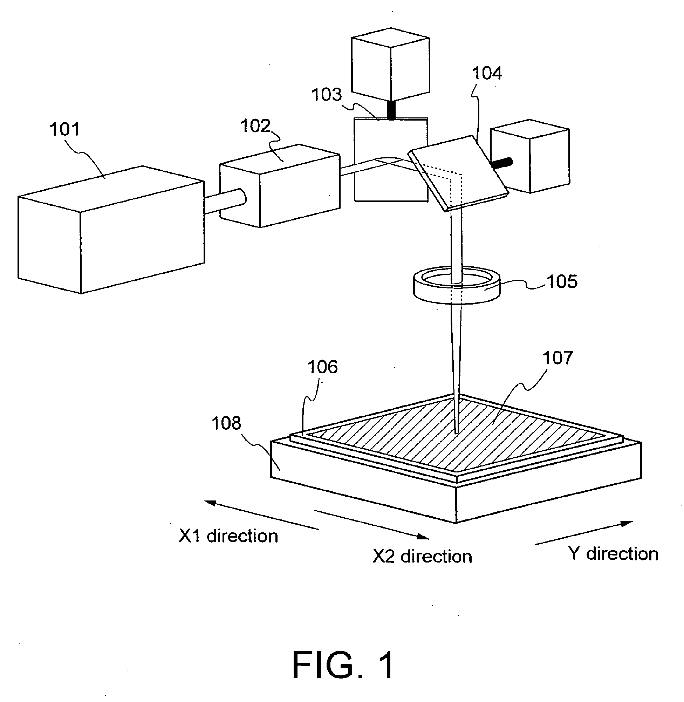

The present embodiment explains an example of the present invention with reference to FIG. 1.

A reference numeral 101 denotes a pulsed laser oscillator having a pulse width that is an order of picosecond or less. The present invention can be applied to any laser when it can oscillate a laser beam having an ultrashort pulse width of 10 ps or less. For example, an excimer laser, an Ar laser, a Kr laser, a $CO_2$ laser, a YAG laser, a $Y_2O_3$ laser, a $YVO_4$ laser, a YLF laser, a $YAlO_3$ laser, a $GdVO_4$ laser, a ceramic laser, a glass laser, a ruby laser, an alexandrite laser, a Ti: sapphire laser, a copper vapor laser, or a gold vapor laser can be used.

This embodiment uses a $YVO_4$ laser having an output power of 2 W. The laser oscillator incorporates a non-linear optical element for emitting a second harmonic (532 nm) that is sufficiently absorbed in an amorphous silicon film. The laser oscillator 101 has a stable resonator and preferably has a spatial profile of $TEM_{00}$ mode. In the case of $TEM_{00}$ mode, the laser beam has Gaussian intensity distribution and is superior in focusing property. Therefore, the beam spot can be easily transformed into a desired shape. The kind and the wavelength of the laser are not limited to those described above, and they may be selected according to an irradiated object 107. In this embodiment, the pulse repetition rate is 80 MHz and the pulse width is 10 ps.

In the laser irradiation apparatus of the present invention, a non-linear optical element may be provided inside a resonator of the laser oscillator 101, or the non-linear optical element may be provided outside the resonator of the laser oscillator 101. The former structure has an advantage that the size of the apparatus becomes compact and that the accurate control of the resonator length is not necessary. The latter structure has an advantage that interaction of the fundamental wave and the harmonic can be ignored.

As the non-linear optical element, the crystal whose non-linear optical constant is relatively large such as KTP ($KTiOPO_4$), BBO ($\beta\text{-}BaB_2O_4$), LBO ($LiB_3O_5$), CLBO ($CsLiB_6O_{10}$), GdYCOB ($YCa_4O(BO_3)_3$), KDP ($KD_2PO_4$), $KB_5$, $LiNbO_3$, $Ba_2NaNb_5O_{15}$, or the like is used. Particularly, the crystal such as LBO, BBO, KDP, KTP, $KB_5$, CLBO, or the like can increase conversion efficiency from the fundamental wave into the harmonic.

A laser beam emitted from the laser oscillator 101 is shaped into a linear beam by an optical system 102 so that a beam spot has a length of 70 $\mu$m in a long side and a length of 10 $\mu$m in a short side on the irradiated object 107. It is noted that the term of linear herein used does not mean a line in a strict sense but means a rectangle having a large aspect ratio (or an oblong). For example, the rectangular having an aspect ratio of 2 or more (preferable in the range of 10 to 10000) is referred to as the linear. It is noted that the linear is still included in the rectangular.

A galvanometer mirror 104 rotates so as to scan the laser beam in X1 and X2 directions (the direction of the short side of the beam spot), while a galvanometer mirror 103 rotates so as to scan the laser beam in a Y direction (the direction of the long side of the beam spot) in FIG. 1. An f$\theta$ lens 105 always focuses the laser beam deflected by the galvanometer mirrors 103 and 104 on an amorphous silicon film 107, which is the irradiated object.

The amorphous silicon film 107 is formed in 66 nm thick over a glass substrate 106 having a thickness of 0.7 mm and a refractive index of 1.52, which is an AN 100 glass substrate manufactured by Asahi Glass Co., Ltd, by a CVD apparatus. When the amorphous silicon film 107 is used as the irradiated object, it is preferable that thermal annealing is performed to the amorphous silicon film 107 before irradiating the laser beam. Specifically, the thermal annealing is performed for approximately one hour in the nitrogenous atmosphere of 500°C for example. This thermal annealing can decrease the amount of hydrogen in the semiconductor film to be $1 \times 10^{20}$ atoms/$cm^3$ or less. When the density of hydrogen in the semiconductor film is high, the film may be damaged by the hydrogen emitted at a burst by the irradiation of the laser beam having high intensity.

The beam spot is scanned in the X1 direction shown in FIG. 1 by driving the galvanometer mirror 104. The moving speed of the beam spot on the irradiated object may be from several tens to several thousand mm/s. In this embodiment, the moving speed is 100 mm/s. After the beam spot is scanned until the end of the laser irradiation region on the irradiated object by driving the galvanometer mirror 104, the galvanometer mirror 103 is driven slightly to move the beam spot in the Y direction. Then, the beam spot is moved by driving the galvanometer mirror 104 again in the X2 direction, which is opposite to the X1 direction, to perform the laser irradiation to the irradiated object. By repeating these operations, the whole surface of the laser irradiation region on the irradiated object can be irradiated with the laser beam.

Even though the galvanometer mirror and the f$\theta$ lens are used, the laser irradiation using the structure of the present invention makes it possible to decrease the effect of the interference between the primary beam irradiated directly and the secondary beam reflected on the rear surface of the substrate and to perform the homogeneous laser irradiation all over the laser irradiation region on the irradiated object. Moreover, since the galvanometer mirror and the fθ lens occupy a small area and provide high throughput, the production efficiency can be improved and the space can be saved while performing the homogeneous laser irradiation.

In the crystallization step of the semiconductor film by the laser, throughput can be increased by shaping the beam spot into an ellipse or a rectangle that is long in one direction and by scanning the beam spot in the direction of its minor axis. The laser beam is shaped into the elliptical when the original shape of the laser beam is circular or near circular. The laser beam whose original shape is rectangular may be also used after transforming the laser beam by expanding it in one direction through a cylindrical lens or the like so that its long side becomes longer. Moreover, a plurality of laser beams each of which is extended long in one direction and shaped into long ellipse or rectangle may be chained in one direction to form a longer beam in order to increase the throughput further.

Moreover, the crystallization using the catalyst metal may be performed. The optimum condition of the laser irradiation is almost the same to both the semiconductor film to which the thermal annealing is performed and the semiconductor film to which the crystallization is performed using the catalyst element. It is noted that a reference numeral 108 denotes a stage.

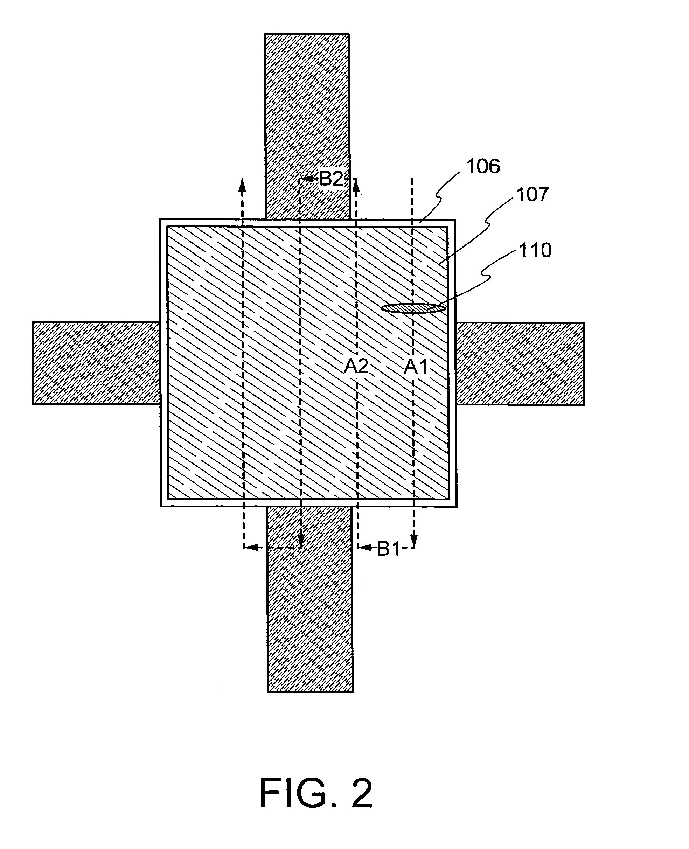

Next, a scanning route of a beam spot 110 on the amorphous silicon film 107 is explained with reference to FIG. 2. The whole surface of the amorphous silicon film 107 is irradiated with the laser beam in such a way that after the beam spot 110 is scanned in one direction using the galvanometer mirror 104, the beam spot 110 is slid using the galvanometer mirror 103 in a direction perpendicular to the direction scanned by the galvanometer mirror 104.

For example, the beam spot 110 is scanned in one direction by the galvanometer mirror 104. In FIG. 2, this scanning route is indicated by a reference character A1. Then, the beam spot 110 is slid in a direction perpendicular to the scanning route A1 using the galvanometer mirror 103. The scanning route by the slide is indicated by a reference character B1. Next, the beam spot 110 is scanned in a direction opposite to the scanning route A1 with the use of the galvanometer mirror 104. This scanning route is indicated by a reference character A2. Next, the beam spot 110 is slid in a direction perpendicular to the scanning route A2 using the galvanometer mirror 103. The scanning route by the slide here is indicated by a reference character B2. By repeating the scanning with the use of the galvanometer mirror 103 and the galvanometer mirror 104 in order, the whole surface of the amorphous silicon film 107 can be irradiated with the laser beam.

In this embodiment, by using the laser beam having an ultrashort pulse width of approximately 10 ps or less, the interference due to the secondary beam reflected on the rear surface of the glass substrate can be suppressed, and the irradiation intensity of the laser beam can be homogenized. Moreover, the irradiation intensity of the laser beam on the irradiated surface can be homogenized even though the laser beam is scanned using the optical system including the galvanometer mirror and the fθ lens. Furthermore, since the laser irradiation apparatus using the galvanometer mirror and the fθ lens occupies a small area and provides high throughput, the production efficiency can be improved while saving the space.

The thickness of the substrate with respect to the pulse width is not limited to that described above, and it may be determined so that the time for which the interference occurs between the primary beam and the secondary beam reflected on the rear surface of the substrate has the significant difference to the pulse width. This difference depends on to what extent the variation between the semiconductor elements to be manufactured can be allowed, and it may be determined by a practitioner appropriately.

[Embodiment 2]

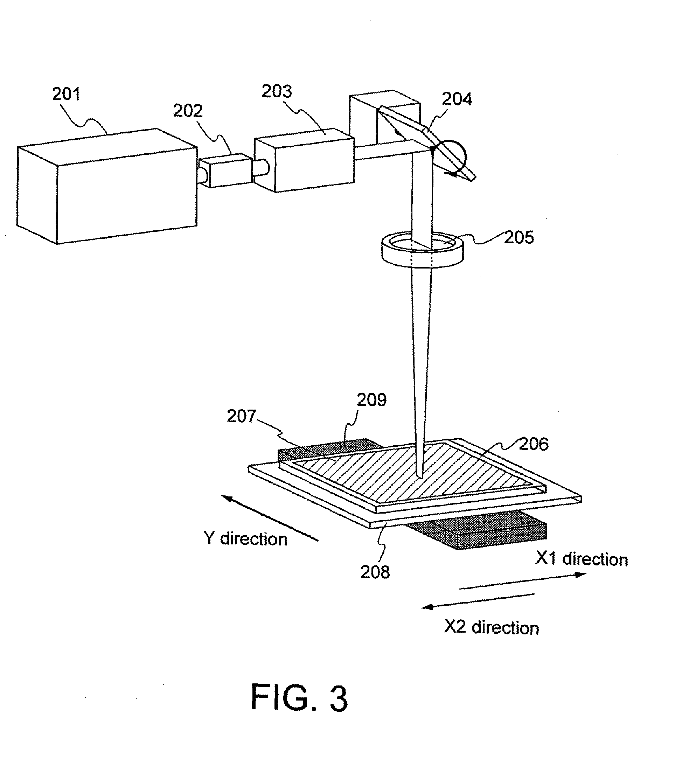

With reference to FIG. 3, this embodiment explains an example of the laser irradiation apparatus including a laser oscillator 201 having a pulse width that is an order of picosecond or less, a galvanometer mirror 204 driving in one direction, an fθ lens 205, a stage 208, and a moving robot 209 moving in one direction.

A laser beam emitted from the laser oscillator 201 is converted into a second harmonic by a non-linear optical element 202 and is shaped into a desired shape by an optical system 203. In this embodiment, the optical system 203 has the structure for shaping the beam spot into linear on the irradiated surface. After that, the galvanometer mirror 204 and the fθ lens 205 are used to scan the linear beam on a semiconductor film 207 formed over a glass substrate 206 in an X1 direction. It is noted that when the linear beam is used, the laser irradiation can be performed efficiently by corresponding the direction of the short side of the linear beam spot with the X1 and X2 directions.

After the beam spot is scanned until the end portion of the laser irradiation region on the semiconductor film 207 in the X1 direction by driving the galvanometer mirror 204, the moving robot 209 is used to move the substrate 206 mounted on the stage 208 in a Y direction in FIG. 3, which is perpendicular to the direction scanned by the galvanometer mirror 204. Next, the beam spot is scanned in an X2 direction by the galvanometer mirror 204 to irradiate the laser beam. By repeating the scanning in this way, the whole surface of the laser irradiation region on the semiconductor film 207 can be irradiated with the laser beam.

Since the other elements in the structure explained in this embodiment are the same as those in the embodiment 1, the explanation is omitted.

In this embodiment, the interference due to the secondary beam reflected on the rear surface of the glass substrate can be suppressed by using the laser beam having an ultrashort pulse width that is an order of picosecond or less even when the laser beam is incident vertically into the irradiated object. Therefore, the irradiation intensity of the laser beam can be homogenized on the irradiated surface while making the laser beam incident vertically into the irradiated object. Moreover, the irradiation intensity of the laser beam on the irradiated surface can be homogenized even though the laser beam is scanned using the optical system including the galvanometer mirror and the fθ lens. Since the laser irradiation apparatus including the galvanometer mirror and the fθ lens occupies a small area and provides high throughput, the production efficiency can be improved while saving the space.

[Embodiment 3]

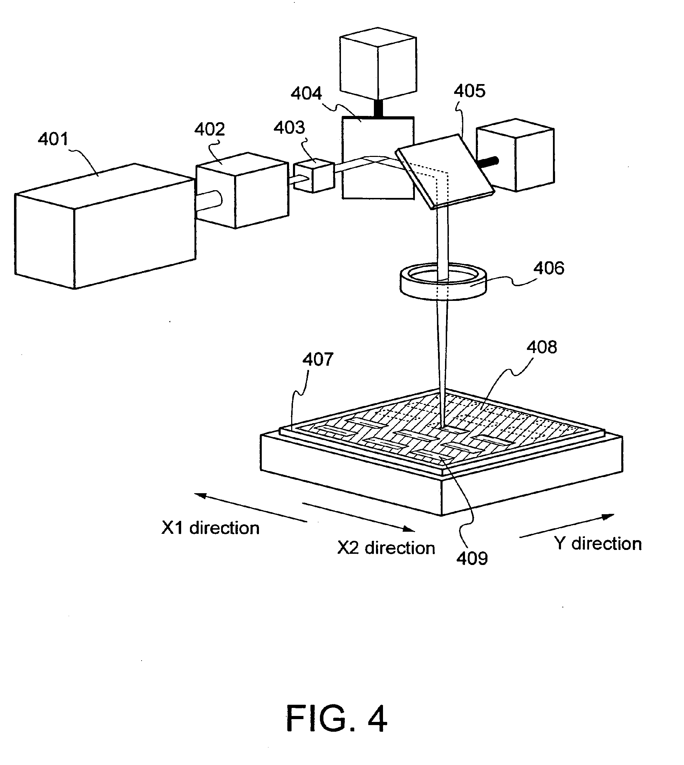

This embodiment explains an example in which the laser beam crystallizes only a part of an amorphous semiconductor film formed over a substrate where a TFT is formed with reference to FIG. 4.

A laser oscillator 401 emits a laser beam having an ultrashort pulse width that is an order of picosecond or less. Specifically, the laser oscillator 401 provides 8 W at 532 nm (second harmonic) with a pulse width of 10 ps and a pulse repetition rate of 80 MHz. The laser beam emitted from the laser oscillator 401 has a beam diameter of 0.6 mm. The laser beam is transformed into a desired shape by an optical system 402. In this embodiment, a cylindrical lens acting on only one direction is used to form a linear beam having a length of 300 μm in a long side and a length of 10 μm in a short side on a semiconductor film 408, which is the irradiated surface, formed over a substrate 407.

The laser beam emitted from the optical system 402 is incident into a shutter 403. The shutter 403 may use an acousto-optic device (A/O device) or an electro-optic device (E/O device) that can switch at the frequency of kilohertz order or more. The A/O device is used in this embodiment.

The traveling direction of the laser beam emitted from the shutter 403 is changed by a galvanometer mirror 404 and a galvanometer mirror 405 in X1, X2 and/or Y directions, and then the laser beam is focused on the semiconductor film 408 formed over the glass substrate 407 by an fθ lens 406. The semiconductor film 408 is herein an amorphous silicon film formed in 66 nm thick over the glass substrate 407 by a plasma CVD apparatus. The glass substrate 407 is an AN100 glass substrate manufactured by Asahi Glass Co., Ltd having a thickness of 0.7 mm and a refractive index of 1.52. It is noted that the amorphous silicon film formed thus includes a large amount of hydrogen. When the laser beam is irradiated to this amorphous silicon film, the hydrogen is emitted at a burst by applying the sudden heat of the laser beam, and the film may be destroyed. In order to prevent this, thermal annealing is performed for one hour in the nitrogenous atmosphere of 500°C.

The laser irradiation is performed in such a way that the beam spot is scanned at a speed of 400 mm/s in a direction of a short side of the beam spot (X1 or X2 direction) by driving the galvanometer mirrors 404 and 405. On this occasion, the shutter 403 operates in conjunction with the galvanometer mirrors 404 and 405 so that only a part 409 of the amorphous silicon film 408 where a TFT is manufactured is irradiated with the laser beam. When the shutter 403, the galvanometer mirror 404, and the galvanometer mirror 405 are controlled at the same time, the laser annealing can be performed only to the part 409 where the TFT is formed.

When the galvanometer mirror is used, the speed can be increased or decreased in short time compared with the case where the stage is used to irradiate the laser beam. Moreover, when the A/O device utilizing an acousto-optic effect or the E/O device utilizing an electro-optic effect is used as the shutter of the laser beam in combination with the galvanometer mirror, only a part where the TFT is manufactured can be irradiated by the laser beam. This can shorten the processing time further.

Furthermore, since the laser beam has an ultrashort pulse width of 10 ps, it is possible to suppress the interference due to the secondary beam reflected on a rear surface of the substrate, to homogenize the irradiation intensity of the laser beam on the irradiated object, and therefore to perform more homogeneous crystallization. Thus, the irradiation intensity of the laser beam on the irradiated surface can be homogenized even when the laser beam is scanned using the optical system including the galvanometer mirror and the fθ lens. Since the laser irradiation apparatus including the galvanometer mirror and the fθ lens occupies a small area and provides high throughput, the production efficiency can be improved while saving the space.

[Embodiment 4]

When a semiconductor film is irradiated with a continuous wave (CW) laser beam, a crystal grain grown continuously in the scanning direction of the beam spot can be obtained. A region where the crystal grain is grown continuously in the scanning direction has superior crystallinity. Therefore, when this region is used as a channel-forming region of a TFT, a TFT having extremely high mobility and on-current can be expected. However, the CW laser has many problems such as a short lifetime of the non-linear optical element, a small beam spot, a serious thermal effect on the substrate, and so on.

Since the present invention uses the laser beam having an ultrashort pulse width, the pulse repetition rate can be increased. Therefore, the pulsed laser beam can be emitted after the semiconductor film is melted by the previous laser beam and before the semiconductor film is solidified. This can form the crystal grain grown continuously to the scanning direction of the beam spot, which is the same as that obtained when the semiconductor film is crystallized by the CW laser beam.

Although the pulse repetition rate is high in the crystallizing process according to the present invention, the laser is not the CW laser but the pulsed laser. Therefore, it is possible to extend the lifetime of the non-linear optical element, to enlarge the beam spot, and to suppress the thermal effect on the substrate. Moreover, the crystal grain grown continuously to the scanning direction having superior crystallinity can be obtained.

When the CW laser is incident into the irradiated object vertically, the interference due to the secondary beam reflected on the rear surface of the substrate occurs and causes the inhomogeneous irradiation of the laser beam. However, with the structure of the present invention, the crystal grain grown continuously to the scanning direction of the beam spot having very superior crystallinity can be obtained while decreasing or preventing the effect of the interference due to the secondary beam reflected on the rear surface of the substrate.

The crystal grain grown continuously in the scanning direction of the beam spot is obtained when the pulse repetition rate is 10 MHz or more, and this repetition rate is extremely higher than that of the pulsed laser to be generally used, which is from several tens to several hundred Hz. It is said that it takes several tens to several hundred ns after the semiconductor film is irradiated with the pulsed laser beam until the semiconductor is solidified completely. When the pulse repetition rate is 10 MHz or more, the pulsed laser beam can be irradiated after the semiconductor film is irradiated with the previous laser beam and before the semiconductor film is solidified. Therefore, unlike the conventional pulsed laser, it is possible to move the interface between the liquid phase and the solid phase continuously in the semiconductor film and to form a semiconductor film having a crystal grain grown continuously in the scanning direction. Specifically, an aggregation of crystal grains each of which has a length of 10 to 30 μm in the scanning direction and a length of approximately 1 to 5 μm in a direction perpendicular to the scanning direction can be obtained.

The region where the crystal grain is grown continuously in the scanning direction by the irradiation of the laser beam has superior crystallinity. Therefore, when this region is used as a channel-forming region of a TFT, the TFT having extremely high mobility and on-current can be expected. However, when the semiconductor film has a region where such high crystallinity is not necessary, the laser beam may not be irradiated to this region. Alternatively, the laser irradiation may be performed under the condition determined so that the high crystallinity is not obtained, for example by increasing the scanning speed.

The present embodiment may be combined with the embodiment mode, the embodiment 1, or the embodiment 2. When the present embodiment is combined with the embodiment 3, it is possible to manufacture a large crystal grain grown continuously in the scanning direction of the laser beam in a desired position (such as a position where the TFT is manufactured) and to shorten the processing time. That is to say, the TFT having considerably high mobility and on-current can be manufactured in a desired position and the other semiconductor elements can be manufactured on a semiconductor film having the crystallization state that is suitable for the respective semiconductor elements.

[Embodiment 5]

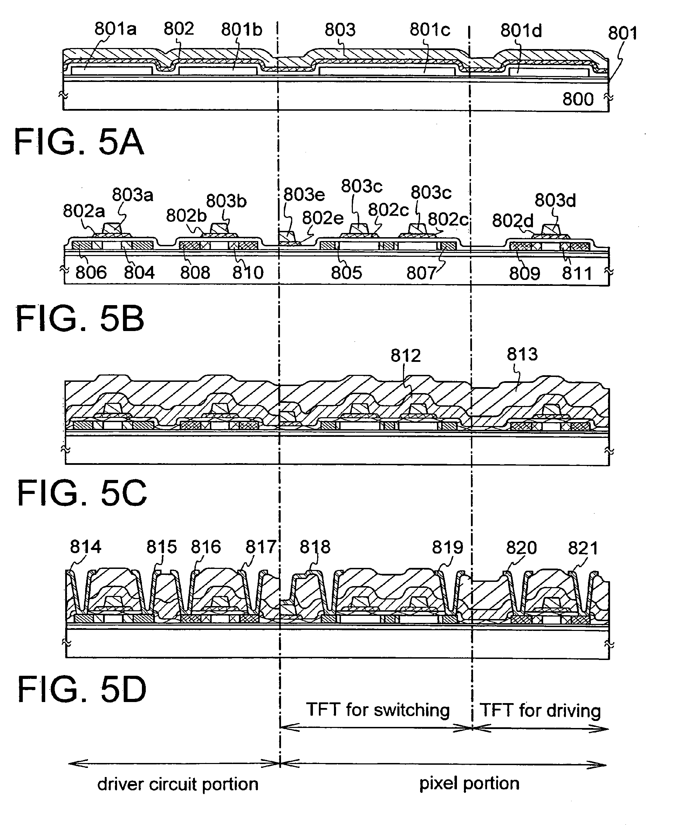

The present embodiment explains a method for manufacturing a semiconductor element used in a display device by means of the laser irradiation apparatus and the laser irradiation method of the present invention with reference to FIGS. 5A to 6B.

A base insulating film 801 is formed over a substrate 800, and then an amorphous silicon film is formed over the base insulating film 801. Next, a crystalline silicon film is formed by irradiating the amorphous silicon film with the laser beam using the laser irradiation apparatus and the laser irradiation method of the present invention.

An insulating substrate such as a glass substrate, a quartz substrate, or a crystalline glass substrate; a ceramic substrate; a stainless substrate; a metal substrate such as tantalum, tungsten, or molybdenum; a semiconductor substrate; a plastic substrate such as polyimide, acrylic, polyethylene terephthalate, polycarbonate, polyarylate, or polyethersulfone; or the like can be used as the substrate 800. It is noted that the substrate 800 needs to be formed of the material that can resist the heat in the manufacturing process. These substrates may be used after being polished by a CMP method or the like as needed. In this embodiment, a glass substrate having a refractive index of 1.5 and a thickness of 0.7 mm is used.

The base insulating film 801 is provided in order to prevent alkali-earth metal or alkali metal included in the substrate 800 from diffusing into the crystalline silicon film. The alkali-earth metal or alkali metal causes an adverse effect on the semiconductor characteristic of the crystalline silicon film when it is in the crystalline silicon film. Therefore, the base insulating film is formed of a single layer of an insulating material such as silicon oxide, silicon nitride, silicon oxynitride, or silicon nitride oxide or formed by laminating the above material. When the substrate hardly diffuses the alkali-earth metal or the alkali metal, the base insulating film is not always necessary to be provided.

In this embodiment, the base insulating film 801 is formed of two layers. A first base insulating film is a silicon nitride oxide film having a thickness of 50 nm, and a second base insulating film is a silicon oxynitride film having a thickness of 100 nm. The difference between the silicon nitride oxide and the silicon oxynitride is the proportion of the nitrogen and oxygen. The silicon nitride oxide film contains more nitrogen than oxygen and the silicon oxynitride film contains more oxygen than nitrogen. The first base insulating film is formed by a plasma CVD method under the condition where $SiH_4$, $N_2O$, $NH_3$, and $H_2$ are used as the material gas, the pressure is 40 Pa, the RF power is 50 W, the RF frequency is 60 MHz, and the substrate temperature is 400°C. The second base insulating film is formed by the plasma CVD method under the condition where $SiH_4$ and $N_2O$ are used as the material gas, the pressure is 40 Pa, the RF power is 150 W, the RF frequency is 60 MHz, and the substrate temperature is 400°C.

Next, an amorphous silicon film is formed in thickness from 25 to 100 nm (preferably from 30 to 60 nm) over the base insulating film by a known method such as a sputtering method, a reduced-pressure CVD method, or a plasma CVD method. In this embodiment, the amorphous silicon film is formed in 50 nm thick by the plasma CVD method.

After that, the amorphous silicon film is crystallized by the laser irradiation. Since the amorphous silicon film contains too much hydrogen, the hydrogen may be bumped by the irradiation of the high laser energy in the crystallization, which may damage the film. Therefore, a heat treatment is performed at a temperature of 500°C for one hour in order to dehydrogenate the amorphous silicon film.

Next, the amorphous silicon film is crystallized by the laser irradiation apparatus of the present invention to form a crystalline semiconductor film. This embodiment uses a galvanometer mirror and an fθ lens to scan the laser beam emitted from a $YVO_4$ laser that provides a power of 2 W at 532 nm (a second harmonic) with a pulse repetition rate of 80 MHz, a spatial profile of $TEM_{00}$ mode, and a pulse width of 7 ps. The beam spot formed on the amorphous silicon film, which is the irradiated object, is shaped into a rectangle having a size of 10 μm in a short side and 70 μm in a long side by the optical system. The condition of the laser irradiation is not limited to that shown in this embodiment.

In the present embodiment, after heating the substrate for an hour in the nitrogenous atmosphere of 500°C, the amorphous silicon film is crystallized by the laser annealing method. Thus, the crystalline silicon film is formed. In the laser annealing process, the scanning speed of the stage is appropriate in the range of several tens to several thousand mm/s, and it is set to 400 mm/s in this embodiment.

In the present embodiment, the optical system including the galvanometer mirror and the fθ lens is used to scan the beam spot. Therefore, the amorphous silicon film has some regions where the laser beam is incident vertically. The laser beam having a wavelength of 532 nm partially transmits through the amorphous silicon film having a thickness of 50 nm and is reflected on a rear surface of the substrate. However, since the pulse width is as short as 7 ps, the time for which the reflected beam interferes with the incident laser beam is very short compared with the conventional case. Thus, the laser irradiation can be performed homogeneously. As a result, the inhomogeneity of the crystallization state can be suppressed and the semiconductor element having stable characteristic can be manufactured. Moreover, since the laser beam is scanned using the optical system including the galvanometer mirror and the fθ lens which don't need a large space and provide high throughput, the production efficiency can be raised while saving the space.

When the pulse repetition rate is set to 10 MHz or more, the crystal grain grown long continuously in the scanning direction of the beam spot can be obtained. By corresponding the scanning direction with the channel direction of the TFT, a TFT having considerably high characteristic can be manufactured. However, this structure is not always necessary to carry out the present invention, and a practitioner may determine the pulse repetition rate as appropriate.

As another crystallization method, a heat treatment may be performed using an element for promoting the crystallization of the amorphous silicon film. As the element for promoting the crystallization, nickel is given typically. With such an element, the crystallization can be performed at low temperature in short time compared with the case where the element is not used. Therefore, this crystallization method is preferable when the substrate does not have much resistance against the heat such as glass substrate. Not only nickel but also iron, palladium, tin, lead, cobalt, platinum, copper, gold, or the like can be used as the element for promoting the crystallization. One or a plurality of elements selected from the above elements may be used.

The element can be added in such a way that the salt of the above element is melted in a solvent and then the solvent is applied by a spin coating method, a dip method, or the like. As the solvent, an organic solvent or water can be used for example. It is necessary to select the solvent, the element, and the salt that don't affect adversely the semiconductor characteristic because they contact the silicon film directly.

After performing the crystallization using the element for promoting the crystallization, the laser beam may be irradiated to improve the crystallinity. On this occasion, the laser irradiation apparatus and the laser irradiation method of the present invention can be employed. The laser to be used and the condition of the laser irradiation in this case are the same as those in the laser crystallization step, and therefore they are not explained here.

Subsequently, a small amount of impurities for controlling the threshold is added as needed to the crystalline semiconductor film, which is so-called channel doping. In order to obtain the required threshold, boron, phosphorous, or the like is added by an ion doping method or the like.

After that, the crystalline silicon film is patterned into a desired shape to form island-shaped crystalline silicon films 801a to 801d as shown in FIG. 5A. The crystalline silicon film is patterned in such a way that after a photo resist is applied on the crystalline silicon film, the photo resist is exposed and annealed so as to form a mask having the desired shape on the crystalline silicon film, and then the crystalline silicon film is etched by a dry etching method using the mask. As the gas used in the dry etching method, $CF_4$, $O_2$, and the like may be used.

Subsequently, a gate insulating film is formed of an insulating film including silicon in thickness from 40 to 150 nm by the plasma CVD method or the sputtering method to cover the crystalline semiconductor films 801a to 801d. In this embodiment, a silicon oxynitride film is formed in 115 nm thick as the gate insulating film by the plasma CVD method.

Next, a tantalum nitride (TaN) film 802 having a thickness of 30 nm is formed over the gate insulating film as a first conductive layer, and a tungsten (W) film 803 having a thickness of 370 nm is formed thereon as a second conductive layer. The TaN film may be formed by the sputtering method using Ta as a target in the nitrogenous atmosphere. The W film may be formed by the sputtering method using W as a target.

Although this embodiment forms the first conductive layer using TaN in 30 nm thick and the second conductive layer using W in 370 nm thick, the materials of these conductive layers are not limited to these elements. Both of the first and the second conductive layers may be formed of the element selected from the group consisting of Ta, W, Ti, Mo, Al, Cu, Cr and Nd, or formed of a chemical compound material or an alloy material including the above element as its main component. In addition, a semiconductor film, typically a poly-crystalline silicon film, with the impurity such as phosphorus doped may be also employed. Moreover, AgPdCu alloy can be also used. Furthermore, the combination of these may be employed appropriately. The film thickness of the first conductive layer is preferably in the range of 20 to 100 nm, and that of the second conductive layer is preferably in the range of 100 to 400 nm. Although the present embodiment shows the two-layer structure, the conductive layer may be formed in a single-layer structure or a multilayer structure including three or more layers.

Next, a resist mask is formed through an exposure process according to the photolithography in order to form an electrode and a wiring by etching the conductive layers. The first etching process is performed under first and second etching conditions. The etching is performed using the resist mask to form a gate electrode and a wiring. The etching conditions are selected appropriately.

An ICP (Inductively Coupled Plasma) etching method is employed in this embodiment. The etching process is initially performed under the first etching condition in which $CF_4$, $Cl_2$, and $O_2$ are used as the etching gas at a gas flow rate of 25/25/10 (sccm) respectively, and plasma is generated by applying 500 W RF (13.56 MHz) electric power to a coil shaped electrode at a pressure of 1.0 Pa. 150 W RF (13.56 MHz) electric power is also applied to the substrate side (sample stage), and substantially a negative self-bias voltage is applied. The W film is etched under the first etching condition, and the edge portions of the first conductive layer are made into a tapered shape.

Next, the etching is performed under the second etching condition. In the second etching condition, $CF_4$ and $Cl_2$ are used as the etching gas at a gas flow rate of 30/30 (sccm) respectively and plasma is generated by applying 500 W RF (13.56 MHz) electric power to a coil shaped electrode at a pressure of 1.0 Pa. Then the etching process is performed for about 15 seconds. 20 W RF (13.56 MHz) electric power is also applied to the substrate side (sample stage), and thereby a negative self-bias voltage is applied substantially. Under the second etching condition using the mixed gas of $CF_4$ and $Cl_2$, both the W film and the TaN film are etched to the same extent. It is noted that in order to perform the etching process without leaving a residue over the gate insulating film, the time for etching may be increased by approximately 10 to 20%. In the first etching process, the gate insulating film not covered by the conductive layers is etched by approximately 20 to 50 nm, and the edge portions of the first and the second conductive layers are made into tapered shape due to the effect of the bias voltage applied to the substrate side.

Next, a second etching process is performed without removing the resist mask. The second etching process is performed under the condition in which $SF_6$, $Cl_2$, and $O_2$ are used as the etching gas at gas flow rate of 24/12/24 (sccm) respectively and plasma is generated by applying 700 W RF (13.56 MHz) electric power to a coil shaped electrode at a pressure of 1.3 Pa. Thus, the etching is performed for approximately 25 seconds. 10 W RF (13.56 MHz) electric power is also applied to the substrate side (sample stage), and thereby a negative self-bias voltage is applied substantially. In this etching condition, the W film is etched selectively and a second shaped conductive layer is formed. On the other hand, the first conductive layer is then hardly etched. The first and the second etching processes form a gate electrode including first conductive layers 802a to 802e and second conductive layers 803a to 803e.

Then, a first doping process is performed without removing the resist mask. The impurity element imparting n-type is doped in the crystalline semiconductor layer at low density through the first doping process. The first doping process may be performed by an ion doping method or an ion implantation method. The ion doping method may be performed under the condition in which the dosage ranges from 1 x $10^{13}$ to 5 x $10^{14}$ ions/$cm^2$ and the acceleration voltage ranges from 40 to 80 kV. In this embodiment, the acceleration voltage is set to 50 kV. The 15th element in the periodic table, typically phosphorus (P) or arsenic (As), can be used as an impurity element imparting n-type. Phosphorus (P) is used in this embodiment. On this occasion, the first conductive layer is used as a mask to form in a self-aligning manner a first impurity region ($N^-$ region) in which the impurity is added at low density.

Next, the resist mask is removed and then a new resist mask is formed. A second doping process is performed at higher accelerating voltage than that in the first doping process. The impurity imparting n-type is also added in the second doping process. The ion doping method may be performed under the conditions where the dosage is in the range of 1 x $10^{13}$ to 3 x $10^{15}$ ions/$cm^2$ and the accelerating voltage is in the range of 60 to 120 kV. In this embodiment, the dosage is set to 3.0 x $10^{15}$ ions/$cm^2$ and the accelerating voltage is set to 65 kV. The second conductive layer is used as the mask against the impurity element in the second doping process, and the doping process is performed so that the impurity element is also added in the semiconductor layer that is positioned below the first conductive layer.

In the second doping process, a second impurity region ($N^-$ region) is formed in the part of the crystalline semiconductor layer that is not overlapped with the second conductive layer or that is not covered by the mask but that is overlapped with the first conductive layer. The impurity imparting n-type is added at density from 1 x $10^{18}$ to 5 x $10^{19}$ atoms/$cm^3$ in the second impurity region. In addition, the impurity imparting n-type is added at high density from 1 x $10^{19}$ to 5 x $10^{21}$ atoms/$cm^3$ in the part of the crystalline semiconductor film that is exposed without being covered by the first conductive layer and the mask (this part is a third impurity region: $N^+$ region). On the other hand, since it is partially covered by only the mask, the density of the impurity in this part covered by only the mask is the same as that when the first doping process is performed, and therefore this part is still referred to as the first impurity region ($N^{--}$ region).

Although each impurity region is formed by performing the doping process twice in the present embodiment, the present invention is not limited to this, and the impurity regions having the desired impurity density may be formed by performing the doping process once or plural times under the conditions determined appropriately.

Next, after removing the resist mask, a resist mask is newly formed to perform a third doping process. The third doping process forms a fourth impurity region ($P^+$ region) and a fifth impurity region ($P^-$ region) in which the impurity element imparting conductivity type opposite to that added in the first and second impurity regions is added.

In the third doping process, the fourth impurity region ($P^+$ region) is formed in the part of the crystalline semiconductor layer that is not covered by the resist mask and that is not overlapped with the first conductive layer. And the fifth impurity region ($P^-$ region) is formed in the part that is not covered by the resist mask and that is not overlapped with the second conductive layer but that is overlapped with the first conductive layer. As the impurity element imparting p-type, the 13th element in the periodic table such as boron (B), aluminum (Al), gallium (Ga), or the like is known.

In the present embodiment, boron (B) is used as the impurity element imparting p-type to form the fourth and the fifth impurity regions by the ion doping method using diborane ($B_2H_6$) under the conditions where the dosage is set to 1 x $10^{16}$ ions/$cm^2$ and the accelerating voltage is set to 80 kV

It is noted that the part where an n-channel TFT is formed is covered by the resist mask through the third doping process.

Here, phosphorus is added in the fourth impurity region ($P^+$ region) and the fifth impurity region ($P^-$ region) at the different density respectively by the first and the second doping processes. However, the third doping process is performed so that the density of the impurity element imparting p-type ranges from 1 x $10^{19}$ to 5 x $10^{21}$ atoms/$cm^3$ in the fourth impurity region ($P^+$ region) and the fifth impurity region ($P^-$ region). Therefore, the fourth impurity region ($P^+$ region) and the fifth impurity region ($P'$ region) work as a source region and a drain region of the p-channel TFT without any problems.

Although the present embodiment forms the fourth impurity region ($P^+$ region) and the fifth impurity region ($P'$ region) by performing the third doping process once, the present invention is not limited to this. The fourth impurity region ($P^+$ region) and the fifth impurity region ($P^-$ region) may be formed by performing the doping process plural times appropriately according to the condition in the doping process.

These doping processes form the first impurity region ($N^-$ region) 804, the second impurity region ($N^-$ region) 805, the third impurity regions ($N^+$ region) 806 and 807, the fourth impurity regions ($P^+$ region) 808 and 809, and the fifth impurity regions ($P^-$ region) 810 and 811. (FIG. 5B)

Next, the resist mask is removed, and then a first passivation film 812 is formed. An insulating film including silicon is formed in thickness from 100 to 200 nm as the first passivation film. A plasma CVD method or a sputtering method may be employed as the film-forming method.

In the present embodiment, a silicon oxide film including nitrogen is formed in 100 nm thick by the plasma CVD method. As the silicon oxide film including nitrogen, a silicon oxynitride film formed using $SiH_4$, $N_2O$, and $NH_3$; a silicon oxynitride film formed using $SiH_4$ and $N_2O$; or a silicon oxynitride film formed using the gas in which $SiH_4$ and $N_2O$ are diluted with Ar can be formed by the plasma-CVD method. In addition, a silicon oxynitride hydride film manufactured using $SiH_4$, $N_2O$, and $H_2$ may be applied as the first passivation film. Of course, the first passivation film 812 may be formed of not only the single-layer structure of the silicon oxynitride film as shown in this embodiment, but also the single layer or multilayer of another insulating film including silicon.

Next, an interlayer insulating film 813 is formed over the first passivation film 812. An inorganic insulating film or an organic insulating film can be used as the interlayer insulating film 813. A silicon oxide film formed by the CVD method or a silicon oxide film applied by an SOG (Spin On Glass) method can be used as the inorganic insulating film. A film of polyimide, polyamide, BCB (benzocyclobutene), acrylic, positive photosensitive organic resin, or negative photosensitive organic resin can be used as the organic insulating film. Moreover, a siloxane film, which is the material whose skeleton structure has Si-O bond and which includes at least hydrogen in the substituent or which includes, in addition to that, at least one of fluorine, alkyl, and aromatic hydrocarbon in the substituent can be used as the organic insulating film. Furthermore, a multilayer structure including the above material may be used.

In this embodiment, the interlayer insulating film 813 is formed of siloxane. The interlayer insulating film 813 is formed in such a way that after applying the siloxane polymer all over the surface, a heat treatment is performed at temperatures from 50 to 200°C for 10 minutes to dry, and then an annealing process is performed at temperatures from 300 to 450°C for 1 to 12 hours. This annealing process forms a siloxane film in 1 μm thick. This process can not only anneal the siloxane polymer but also hydrogenate the semiconductor layer using hydrogen in the first passivation film 812 and activate the impurity in the semiconductor layer. Therefore, the number of processes can be decreased, and the process can be simplified. The hydrogenation is to terminate the dangling bond of the semiconductor layer using the hydrogen included in the first passivation film. (FIG. 5C)

When the interlayer insulating film is formed of the material different from the siloxane, another heat treatment is needed for the hydrogenation and the activation. In this case, this heat treatment is required before forming the interlayer insulating film. The heat treatment may be performed in the nitrogenous atmosphere from 400 to 700°C including oxygen for 1 ppm or less, preferably 0.1 ppm or less. Instead of this heat treatment, a laser annealing method or a rapid thermal annealing (RTA) method can be applied. In the laser annealing method, the laser irradiation apparatus and the laser irradiation method of the present invention can be used.

The heat treatment for the activation may be performed before forming the first passivation film 812. However, when the materials of the first conductive layers 802a to 802e and the second conductive layers 803a to 803e don't have enough resistance against the heat, it is preferable to perform the heat treatment after forming the first passivation film 812 in order to protect the wiring and the like as shown in the present embodiment. Moreover, in this case, since the first passivation film does not exist, the hydrogenation using the hydrogen included in the passivation film cannot be performed. In this case, the hydrogenation may be performed using hydrogen excited to be plasma (plasma hydrogenation) or may be performed by a heat treatment for 1 to 12 hours in the atmosphere from 300 to 450°C including hydrogen in the range of 3 to 100%.

After that, a silicon nitride oxide film or a silicon oxynitride film may be formed to cover the interlayer insulating film 813. When a conductive layer to be formed later is etched, the silicon nitride oxide film or the silicon oxynitride film works as an etching stopper to prevent the interlayer insulating from being overetched. Moreover, a silicon nitride film may be formed over the silicon nitride oxide film or the silicon oxynitride film by the sputtering method. Since this silicon nitride film suppresses the moving of an alkali-metal ion, it is possible to suppress that the metal ion such as lithium or sodium moves from an pixel electrode to be formed later to the semiconductor thin film.

Next, a contact hole reaching the crystalline semiconductor layers 801a to 801d is formed by patterning and etching the interlayer insulating film. Specifically, the contact hole is formed in such a way that a siloxane film is etched using the mixed gas of $CF_4$, $O_2$, and He and then the silicon oxide film as the gate insulating film is etched away using $CHF_3$ gas.

Subsequently, a plurality of metal films are formed in the contact hole, and they are patterned to form a source electrode and a drain electrode. In this embodiment, a titanium film including nitrogen is formed in 100 nm thick, a titanium-aluminum alloy film is formed in 350 nm thick thereon, and a titanium film is further formed in 100 nm thick on the titanium-aluminum alloy film. After that, source electrodes and/or drain electrodes 814 to 821 are formed by patterning and etching these three layers into a desired shape. (FIG. 5D)

The titanium film including nitrogen is formed by the sputtering method under the condition where titanium is used as the target, and the flow ratio between nitrogen and Ar is 1:1. When the titanium film including nitrogen is formed over the siloxane interlayer insulating film, the wiring that is hard to be peeled and that has low-resistance connection with the crystalline silicon film can be formed.

The above processes can manufacture a semiconductor element such as a TFT or a capacitor. When the semiconductor film used for the semiconductor element such as the TFT or the capacitor is crystallized using the laser irradiation apparatus and the laser irradiation method of the present invention, it is possible to obtain high throughput while suppressing the interference due to the secondary beam reflected on a rear surface of the substrate. As a result, the characteristic of the semiconductor element formed over the substrate can be made more homogeneous while improving the production efficiency. When such a semiconductor element is used as a pixel portion of the display device, it is possible to prevent the variation of the characteristic of the TFT due to the inhomogeneous crystallization state from being visible. This makes it possible to provide the display device having the image of high quality at lower cost than before.

[Embodiment 6]

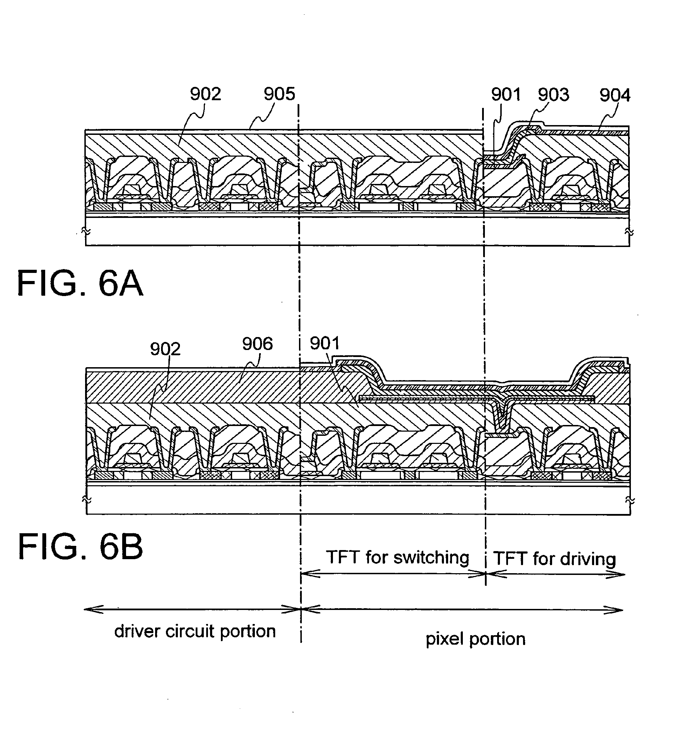

This embodiment explains an example in which the element substrate obtained in the embodiment 3 is used to manufacture a light-emitting display device with reference to FIGS. 6A and 6B. The light-emitting display device explained in this embodiment is that light-emitting elements are arranged in a matrix form, and the light-emitting elements have a layer including a light-emitting material sandwiched between a pair of electrodes and emit light by supplying current between the pair of electrodes.

As the excited state of the light-emitting element, a singlet-excited state and a triplet-excited state are known. It is considered that the light emission is possible by any one of them. Therefore, according to the characteristic of the light-emitting element, a light-emitting display device may include both an element of the singlet-excited state and an element of the triplet-excited state. For example, among the three colors of R (red), G (green), and B (blue), the element of triplet-excited state may be used as R, and the elements of singlet-excited state may be used as B and G. Since the element of the triplet-excited state obtains high emission efficiency in general, it contributes to the lowering of the driving voltage.

As the material of the light-emitting element, there are low-molecular-weight light-emitting material, a high-molecular-weight light-emitting material, and a medium-molecular-weight light-emitting material having an intermediate property between the former two light-emitting materials. In this embodiment, the low-molecular-weight light-emitting material is used. Both the low-molecular-weight material and the high-molecular-weight material can be applied by spin coating or an ink jet method when they are melted in a solvent. Moreover, not only an organic material but also a complex material of the organic material and an inorganic material can be used.

A first electrode 901 of the light-emitting element is formed in such a way that the first electrode 901 overlaps partially with the drain electrode of the TFT manufactured in the former step. The first electrode is an anode or a cathode of the light-emitting element. When the first electrode is the anode, it is preferable to use metal, alloy, conductive compound, or mixture of these each having the work function as high as approximately 4.0 eV or more as the anode material. Specifically, ITO (indium tin oxide), IZO (indium zinc oxide) including indium oxide in which zinc oxide (ZnO) is mixed in the range of 2 to 20%, ITSO including indium oxide in which silicon oxide ($SiO_2$) is mixed in the range of 2 to 20%, gold (Au), platinum (Pt), nickel (Ni), tungsten (W), chromium (Cr), molybdenum (Mo), iron (Fe), cobalt (Co), copper (Cu), palladium (Pd), or the metallic nitride material such as TiN can be used as the anode material.

When the first electrode is the cathode, it is preferable to use metal, alloy, conductive compound, a mixture of these, or the like each having the work function as low as approximately 3.8 eV or less as the cathode material. Specifically, the cathode can be formed of the material such as the element belonging to the first group or the second group in the periodic table, for example alkali metal such as Li or Cs; Mg; alkali-earth metal such as Ca or Sr; alloy including these such as Mg-Ag or Al-Li; a chemical compound such as LiF, CsF, or $CaF_2$; or transition metal including the rare-earth metal. However, since the first electrode is formed so that the light transmits therethrough in this embodiment, the first electrode is formed by forming these metals or the alloy including these metals extremely thinly and by laminating the material such as ITO, IZO, ITSO, or another metal (including alloy).

In this embodiment, the first electrode 901 is an anode formed of ITSO. When ITSO is used as the electrode, the reliability of the light-emitting display device is enhanced by performing the vacuum bake.

Although the first electrode is formed after manufacturing the source electrode and the drain electrode of the TFT in the present embodiment, the first electrode may be formed before manufacturing the electrodes of the TFT.

An insulating film 902 is formed to cover an edge portion of the first electrode 901, which is a pixel electrode connected to the TFT of the pixel portion. The insulating film 902 is referred to as a bank or a partition wall. As the insulating film 902, an inorganic insulating film or an organic insulating film can be used. As the inorganic insulating film, there are a silicon oxide film formed by the CVD method, a silicon oxide film applied by the SOG (Spin On Glass) method, and so on. As the organic insulating film, there are photosensitive or nonphotosensitive polyimide, polyamide, BCB (benzocyclobutene), acrylic, positive photosensitive organic resin, or negative photosensitive organic resin. Moreover, a siloxane film, which is formed of the material whose skeleton structure has Si-O bond and which includes at least hydrogen in the substituent or which includes, in addition to hydrogen, at least one of fluorine, alkyl, and aromatic hydrocarbon in the substituent can be used as the organic insulating film. Furthermore, a multilayer structure including the above material may be used. It is preferable to use the photosensitive organic material because an opening having the cross-sectional shape whose radius of curvature continuously changes is formed so that an electroluminescent layer can be vapor-deposited while suppressing the breakage due to the step. Thus, the photosensitive polyimide is used in this embodiment.

Subsequently, the vapor deposition is performed using the vapor deposition apparatus in such a way that the vapor deposition source is moved in a film-forming chamber that is vacuumed so that the degree of vacuum is 0.667 Pa or less, preferably in the range of 1.33 x $10^{-2}$ to 1.33 x $10^{-4}$ Pa. At the vapor deposition, the organic compound is vaporized in advance due to the resistant heat, and it is spattered toward the substrate by opening the shutter. The vaporized organic compound is spattered upward and deposited on the substrate through an opening provided in the metal mask to form an electroluminescent layer 903 (including a hole-injecting layer, a hole-transporting layer, a light-emitting layer, a laminated body, and an electron-injecting layer from the side of the first electrode). It is noted that the structure of the electroluminescent layer 903 is not limited to the above, and it may be a single layer. When the electroluminescent layer 903 has the laminated-layer structure, adjacent layers may sandwich therebetween a layer in which the respective materials of the adjacent layers are mixed.

After forming the electroluminescent layer 903, a second electrode 904 is formed so as to contact the electroluminescent layer 903. Since the first electrode 901 is the anode in the present embodiment, the second electrode 904 is formed as the cathode. As the material of the cathode, the material mentioned above may be used. In this embodiment, the second electrode (cathode) 904 is an aluminum film having a thickness of 150 nm.

Since only the first electrode 901 is formed of the light-transmitting material in the present embodiment, the light is taken out from the bottom surface of the substrate. FIG. 6B is an example of a top-emission structure in which the pixel electrode 901, which is the first electrode, and the electrode of the TFT are formed in the different layer. The first interlayer insulating film 902 and a second interlayer insulating film 906 can be formed of the same material as that of the interlayer insulating film 813 shown in FIG. 5C, and the combination of the materials of the first and the second interlayer insulating films can be selected freely. In this embodiment, both layers are formed of siloxane. The pixel electrode 901 is formed by laminating Al-Si alloy, TiN, and ITSO in this order from the side of the second interlayer insulating film 906. The structure is not limited to this, and it may be a single-layer structure or a multilayer structure including two layers or four or more layers.

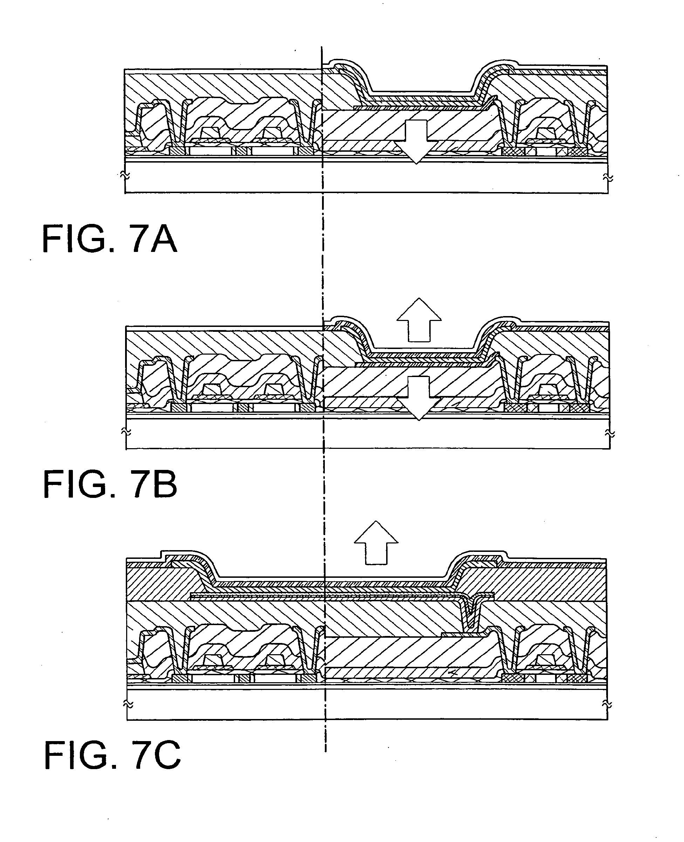

FIGS. 7A to 7C show examples of a bottom-emission structure, a dual-emission structure, and a top-emission structure respectively. The structure in which the light is taken out from the bottom surface of the substrate described in the present embodiment corresponds to the bottom-emission structure in FIG. 7A.

When a material including Li is formed under the second electrode in the thickness of such a degree that the light can transmit and the second electrode is formed of the light-transmitting material such as ITO, ITSO, or IZO, the light-emitting display device having the dual-emission structure in which the light is taken out from both the top surface and the bottom surface of the substrate shown in FIG. 7B can be obtained. It is noted that even though aluminum or silver formed thickly does not transmit the light, aluminum or silver can transmit the light when it is formed very thinly. Therefore, when the second electrode is formed of aluminum or silver in the thickness of such a degree that the light can transmit, the dual-emission structure can be obtained.

FIG. 7C is an example of a top-emission light-emitting display device, which is the same structure as that in FIG. 6B. When the number of interlayer films is increased by one compared with the structure of FIGS. 7A and 7B, another light-emitting element can be provided above the TFT, which is advantageous in point of the numerical aperture.

Since the transparent electrode such as ITO or ITSO, which is used in the dual-emission structure or the top-emission structure, cannot be formed by the vapor deposition method, it is formed by the sputtering method. When the second electrode 904 is formed by the sputtering method, the surface of the electron-injecting layer or an interface between the electron-injecting layer and the electron-transporting layer may be damaged by the sputtering, and the characteristic of the light-emitting element may be adversely affected. In order to prevent this, it is preferable to provide a material that is hard to be damaged by the sputtering in the position closest to the second electrode 904. Molybdenum oxide ($MoO_x$) is given as the material that is hard to be damaged by the sputtering and that can be used as the electroluminescent layer 903. However, since $MoO_x$ is the preferable material as the hole-injecting layer, it is necessary that the second electrode 904 is the anode in order to provide $MoO_x$ in contact with the second electrode 904. The element in which the first electrode is the cathode and the second electrode is the anode is referred to as a reversely laminated element in this specification.

In the case of the reversely laminated element, the first electrode 901 is formed as the cathode, and then the electron-injecting layer, the electron-transporting layer, the light-emitting layer, the hole-transporting layer, the hole-injecting layer ($MoO_x$), and the second electrode (anode) are formed in order. It is necessary that the TFT for driving the pixel is an n-channel type.

$MoO_x$ is formed by the vapor deposition method, and it is preferable that x is in the range of 3.1 to 3.2. Moreover, the $MoO_x$ layer may be a layer in which an organic material and an inorganic material are mixed by co-evaporating the organic material and an organic metal complex such as copper phthalocyanine (CuPc). In the case of using the reversely laminated element, it is preferable that the TFT of the pixel portion employs the transistor using an a-Si:H that is originally N-type as the semiconductor layer because the process can be simplified. When the driver circuit portion is formed over the same substrate, only the driver circuit portion may be crystallized by the laser irradiation method of the present invention.

After that, a silicon oxide film including nitrogen is formed as a second passivation film 905 by the plasma CVD method. As the silicon oxide film including nitrogen, a silicon oxynitride film manufactured using $SiH_4$, $N_2O$, and $NH_3$; a silicon oxynitride film manufactured using $SiH_4$ and $N_2O$; or a silicon oxynitride film manufactured using the gas in which $SiH_4$ and $N_2O$ are diluted with Ar may be formed by the plasma CVD method. Moreover, a silicon oxynitride hydride film manufactured using $SiH_4$, $N_2O$, and $H_2$ may be used as the first passivation film. The second passivation film 905 is not limited to a single layer of the silicon oxide film including nitrogen, and it may be formed of a single layer or multilayer of another insulating film including silicon. Moreover, multilayer of a carbon nitride film and a silicon nitride film; multilayer of styrene polymer; a silicon nitride film; or a diamond-like-carbon film may be used instead of the silicon oxide film including nitrogen.

Subsequently, in order to protect the electroluminescent element from the material promoting the deterioration such as water, the display portion is sealed. When an opposing substrate is used to seal the display portion, the element substrate and the opposing substrate are pasted with the use of an insulative sealing material so as to expose an external connection portion. The space between the opposing substrate and the element substrate may be filled with the inert gas such as dry nitrogen, or the sealing material may be applied all over the pixel portion in which the opposing substrate is formed. As the sealing material, it is preferable to use ultraviolet curable resin. A drying agent or a particle for keeping the same gap may be mixed into the sealing material. Subsequently, the flexible wiring substrate is pasted to the external connection portion, and this completes an electroluminescent panel.

Such an electroluminescent panel displays the image in various ways. For example, the electroluminescent panel displays the image with a single color, an area color, a full color, or the like. In the case of the full-color display, there are a method in which R, G, and B are manufactured individually, a method in which R, G, and B are obtained by providing a color filter to a white light source, a method in which a color having a short wavelength is converted into a color having a long wavelength using a color-conversion filter, and so on. Moreover, a color filter may be used to improve the color purity.

It is noted that one of an analog video signal and a digital video signal may be used in the light-emitting display device of the present invention. In the digital video signal, there are a video signal using the voltage and a video signal using the current. The video signal input into the pixel uses the constant voltage or the constant current when the light-emitting element emits light. When the video signal uses the constant voltage, the voltage applied to the light-emitting element or the current flowing in the light-emitting element is constant. On the other hand, when the video signal uses the constant current, the voltage applied to the light-emitting element or the current flowing in the light-emitting element is constant. The former one in which the constant voltage is applied to the light-emitting element is referred to as a constant voltage drive, while the latter one in which the constant current flows in the light-emitting element is referred to as a constant current drive. The constant current flows in the light-emitting element driven by the constant current without being affected by the change of the resistance of the light-emitting element. Any one of the video signal using the constant voltage and the video signal using the constant current may be used in the light-emitting device and its driving method of the present invention. Moreover, the light-emitting device of the present invention may be used by any one of the constant voltage drive and the constant current drive.

[Embodiment 7]

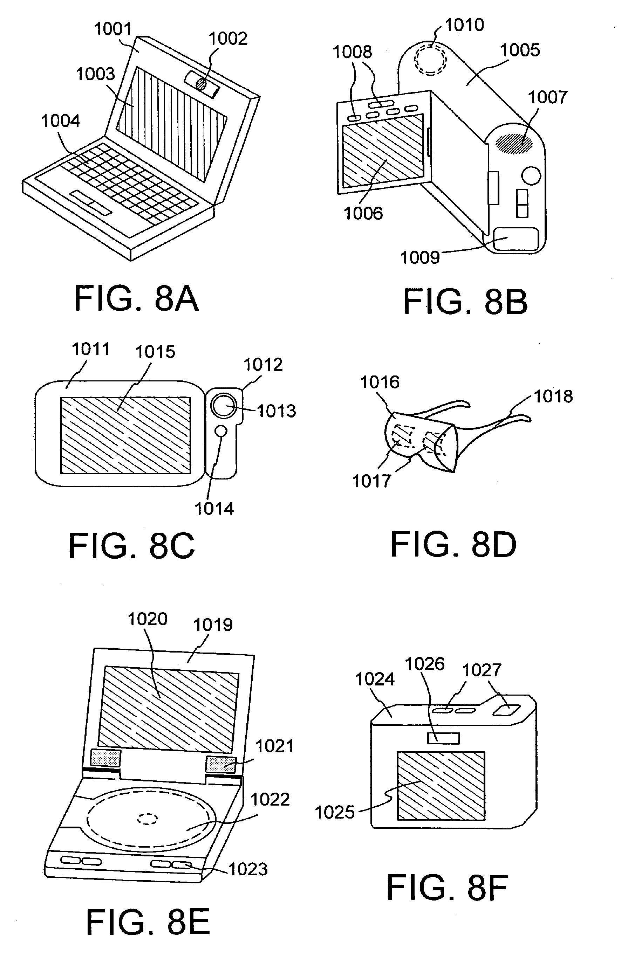

Although the embodiment 6 showed the example in which the present invention is applied to the light-emitting display device, the present invention can be applied to any other electronic devices that have a semiconductor element including a thin film formed by applying the laser annealing or laser crystallization. Since the characteristic of the semiconductor element manufactured by the present invention has less variation, it is possible to provide a product having the stable quality. As the examples of such electronic devices, a camera such as a video camera and a digital camera, a head mounted display (goggle type display), a car navigation, a car stereo, a personal computer, portable information terminal (such as a mobile computer, a cellular phone, an electronic book, and the like) and the like. These examples are shown in FIG. 8A to 9C. Or, the present invention can be applied to general electronic devices such as IC chip, ID chip, and RFID.

FIG. 8A shows a personal computer, comprising a main body 1001, an image reader 1002, a display portion 1003, a key board 1004, and the like. A semiconductor element formed by applying the laser irradiation method of the present invention can be applied to the display portion 1003. The semiconductor element formed by applying the laser irradiation method of the present invention has less variation, it is possible to provide a stable display quality.

FIG. 8B shows a video camera, comprising a main body 1005, a display portion 1006, a voice input portion 1007, an operating switch 1008, a battery 1009, an image receiver 1010, and the like. A semiconductor element formed by applying the laser irradiation method of the present invention can be applied to the display portion 1006. The semiconductor element formed by applying the laser irradiation method of the present invention has less variation, it is possible to provide a stable display quality.

FIG. 8C shows a mobile computer, comprising a main body 1011, a camera portion 1012, an image receiver 1013, an operating switch 1014, a display portion 1015 and the like. A semiconductor element formed by applying the laser irradiation method of the present invention can be applied to the display portion 1015. The semiconductor element formed by applying the laser irradiation method of the present invention has less variation, it is possible to provide a stable display quality.

FIG. 8D shows a goggle type display, comprising a main body 1016, a display portion 1017, an arm portion 1018 and the like. The display portion 1017 includes a flexible substrate which is inflected to manufacture the goggle type display. In addition, the goggle type display can be made lightweight and thin. A semiconductor element formed by applying the laser irradiation method of the present invention can be applied to the display portion 1017. The semiconductor element formed by applying the laser irradiation method of the present invention has less variation, it is possible to provide a stable display quality.

FIG. 8E shows a player utilizing a recording medium that has a program recorded (hereinafter referred to as a recording medium), comprising a main body 1019, a display portion 1020, a speaker portion 1021, a recording medium 1022, an operating switch 1023 and the like. It is noted that this player enables to enjoy listening to the music, watching the movies, playing the game, and playing on the Internet using a DVD (Digital Versatile Disc), CD or the like as its recording medium. A semiconductor element formed by applying the laser irradiation method of the present invention can be applied to the display portion 1020. The semiconductor element formed by applying the laser irradiation method of the present invention has less variation, it is possible to provide a stable display quality.

FIG. 8F shows a digital camera, comprising a main body 1024, a display portion 1025, an eye piece 1026, an operating switch 1027, an image receiver (not shown in the figure) and the like. A semiconductor element formed by applying the laser irradiation method of the present invention can be applied to the display portion 1025. The semiconductor element formed by applying the laser irradiation method of the present invention has less variation, it is possible to provide a stable display quality.

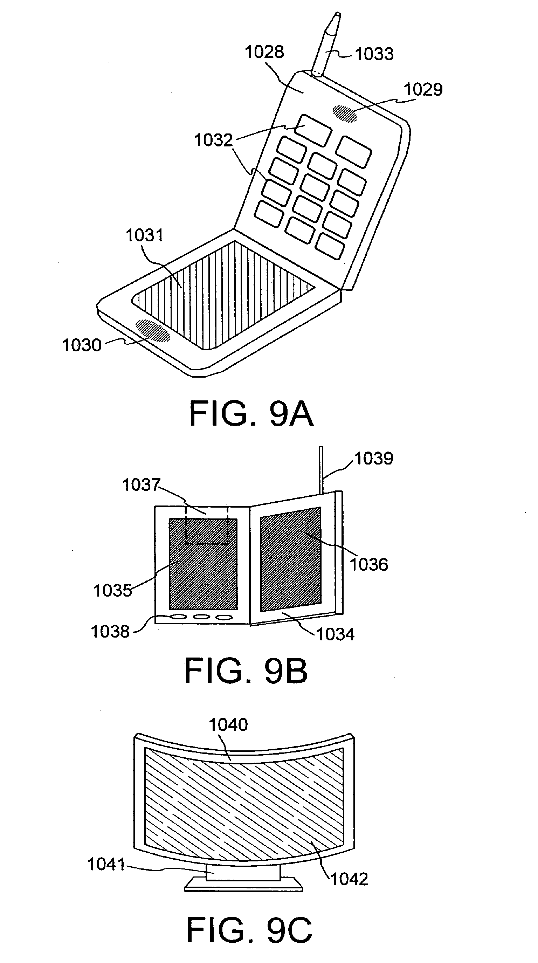

FIG. 9A shows a cellular phone, comprising a main body 1028, a voice output portion 1029, a voice input portion 1030, a display portion 1031, an operating switch 1032, an antenna 1033 and the like. A semiconductor element formed by applying the laser irradiation method of the present invention can be applied to the display portion 1031. The semiconductor element formed by applying the laser irradiation method of the present invention has less variation, it is possible to provide a stable display quality.

FIG. 9B shows a mobile book (electronic book), comprising a main body 1034, display portions 1035 and 1036, a recording medium 1037, an operating switch 1038, an antenna 1039 and the like. A semiconductor element formed by applying the laser irradiation method of the present invention can be applied to the display portions 1035 and 1036. The semiconductor element formed by applying the laser irradiation method of the present invention has less variation, it is possible to provide a stable display quality.

FIG. 9C shows a display, comprising a main body 1040, a supporting stand 1041, a display portion 1042 and the like. The display portion 1042 is manufactured with a flexible substrate, and thereby the light and thin display can be realized. Moreover, it is possible to inflect the display portion 1042. A semiconductor element formed by applying the laser irradiation method of the present invention can be applied to the display portion 1042. The semiconductor element formed by applying the laser irradiation method of the present invention has less variation, it is possible to provide a stable display quality. The present invention is advantageous especially in manufacturing a large-sized display having a length of 10 inch or more (especially more than 30 inch) diagonally.

The present invention can be widely applied to the various kinds of electronic devices. It is noted that these electronic devices described in this embodiment can be combined any of the embodiment mode and the embodiments 1 to 6. Moreover, by using the galvanometer mirror and the fθ lens, the characteristic of the semiconductor element formed over the substrate can be more homogeneous while improving the production efficiency. Therefore, a display device being able to provide an image of high quality can be supplied at lower cost than before.

Furthermore, with the miniaturization and the integration of the semiconductor device in recent years, the semiconductor film to be used in the thin film semiconductor element typified by a TFT is becoming thinner and thinner according to the miniaturization of the design rule. In this trend, the interference due to the secondary laser beam that transmits through the semiconductor film and reflects on the rear surface of the substrate is a significant problem. However, the present invention can avoid the interference and manufacture the semiconductor film having the crystallinity that is more homogeneous.

This application is based on Japanese Patent Application serial No. 2003-433357 filed in Japan Patent Office on 26th, December 2003, the contents of which are hereby incorporated by reference.

## Claims

1. A laser irradiation apparatus comprising:

   a laser oscillator;
   at least one mirror for deflecting a laser beam emitted from the laser oscillator in one direction; and
   a lens for having the laser beam deflected by the mirror form an image on a predetermined plane,

   wherein a pulse width t of the laser beam emitted from the laser oscillator satisfies an inequality ct<2nd where d is a distance between a focal point of the lens and a stage for mounting an irradiated object thereon, n is 1.5, and c is a speed of light in vacuum.

2. A laser irradiation apparatus comprising:

   a laser oscillator;
   at least one mirror for deflecting a laser beam emitted from the laser oscillator in one direction; and
   a lens for having the laser beam deflected by the mirror form an image on a predetermined plane,

   wherein a pulse width t of the laser beam emitted from the laser oscillator satisfies an inequality ct<4nd where d is a distance between a focal point of the lens and a stage for mounting an irradiated object thereon, n is 1.5, and c is a speed of light in vacuum.

3. A laser irradiation apparatus comprising:

   a laser oscillator;
   at least one galvanometer mirror; and
   an fθ lens,

   wherein a pulse width t of a laser beam emitted from the laser oscillator satisfies an inequality ct<2nd where d is a distance between a focal point of the fθ lens and a stage for mounting an irradiated object thereon, n is 1.5, and c is a speed of light in vacuum.

4. A laser irradiation apparatus comprising:

   a laser oscillator;
   at least one galvanometer mirror; and
   an fθ lens,

   wherein a pulse width t of a laser beam emitted from the laser oscillator satisfies an inequality ct<4nd where d is a distance between a focal point of the fθ lens and a stage for mounting an irradiated object thereon, n is 1.5, and c is a speed of light in vacuum.

5. A laser irradiation apparatus comprising:

   a laser oscillator;
   a first mirror for scanning a beam spot of a laser beam emitted from the laser oscillator on an irradiated object in a first direction;
   a second mirror for scanning the beam spot of the laser beam emitted from the laser oscillator on the irradiated object in a second direction perpendicular to the first direction; and
   an fθ lens for having the laser beam form an image on the irradiated object,

   wherein a pulse width t of the laser beam satisfies an inequality ct<2nd where d is a distance between a focal point of the fθ lens and a stage for mounting the irradiated object thereon, n is 1.5, and c is a speed of light in vacuum.

6. A laser irradiation apparatus comprising:

   a laser oscillator;
   a first mirror for scanning a beam spot of a laser beam emitted from the laser oscillator on an irradiated object in a first direction;
   a second mirror for scanning the beam spot of the laser beam emitted from the laser oscillator on the irradiated object in a second direction perpendicular to the first direction; and
   an fθ lens for having the laser beam form an image on the irradiated object,

   wherein a pulse width t of the laser beam satisfies an inequality ct<4nd where d is a distance between a focal point of the fθ lens and a stage for mounting the irradiated object thereon, n is 1.5, and c is a speed of light in vacuum.

7. A laser irradiation apparatus comprising:

   a laser oscillator;
   a mirror for scanning a beam spot of a laser beam emitted from the laser oscillator on an irradiated object in a first direction;
   a stage for mounting the irradiated object thereon and for moving in a second direction perpendicular to the first direction; and
   an fθ lens for having the laser beam form an image on the irradiated object,

   wherein a pulse width t of the laser beam satisfies an inequality ct<2nd where d is a distance between a focal point of the fθ lens and the stage for mounting the irradiated object thereon, n is 1.5, and c is a speed of light in vacuum.

8. A laser irradiation apparatus comprising:

    a laser oscillator;
    a mirror for scanning a beam spot of a laser beam emitted from the laser oscillator on an irradiated object in a first direction;
    a stage for mounting the irradiated object thereon and for moving in a second direction perpendicular to the first direction; and
    an fθ lens for having the laser beam form an image on the irradiated object,

    wherein a pulse width t of the laser beam satisfies an inequality ct<4nd where d is a distance between a focal point of the fθ lens and the stage for mounting the irradiated object thereon, n is 1.5, and c is a speed of light in vacuum.

9. The laser irradiation apparatus according to claim 1, wherein the laser beam emitted from the laser oscillator is a second harmonic or is converted into the second harmonic.

10. The laser irradiation apparatus according to claim 2, wherein the laser beam emitted from the laser oscillator is a second harmonic or is converted into the second harmonic.

11. The laser irradiation apparatus according to claim 3, wherein the laser beam emitted from the laser oscillator is a second harmonic or is converted into the second harmonic.

12. The laser irradiation apparatus according to claim 4, wherein the laser beam emitted from the laser oscillator is a second harmonic or is converted into the second harmonic.

13. The laser irradiation apparatus according to claim 5, wherein the laser beam emitted from the laser oscillator is a second harmonic or is converted into the second harmonic.

14. The laser irradiation apparatus according to claim 6, wherein the laser beam emitted from the laser oscillator is a second harmonic or is converted into the second harmonic.

15. The laser irradiation apparatus according to claim 7, wherein the laser beam emitted from the laser oscillator is a second harmonic or is converted into the second harmonic.

16. The laser irradiation apparatus according to claim 8, wherein the laser beam emitted from the laser oscillator is a second harmonic or is converted into the second harmonic.

17. The laser irradiation apparatus according to claim 1, further comprising:

    a shutter using an acousto-optic device or an electro-optic device.

18. The laser irradiation apparatus according to claim 2, further comprising:

    a shutter using an acousto-optic device or an electro-optic device.

19. The laser irradiation apparatus according to claim 3, further comprising:

    a shutter using an acousto-optic device or an electro-optic device.

20. The laser irradiation apparatus according to claim 4, further comprising:

    a shutter using an acousto-optic device or an electro-optic device.

21. The laser irradiation apparatus according to claim 5, further comprising:

    a shutter using an acousto-optic device or an electro-optic device.

22. The laser irradiation apparatus according to claim 6, further comprising:

    a shutter using an acousto-optic device or an electro-optic device.

23. The laser irradiation apparatus according to claim 7, further comprising:

    a shutter using an acousto-optic device or an electro-optic device.

24. The laser irradiation apparatus according to claim 8, further comprising:

    a shutter using an acousto-optic device or an electro-optic device.

25. A method for manufacturing a crystalline semiconductor film comprising:

    forming an amorphous semiconductor film over a substrate having a refractive index n and a thickness d; and
    irradiating the amorphous semiconductor film with a laser beam having a pulse width t that satisfies an inequality ct<2nd where c is a speed of light using an optical system including at least one galvanometer mirror and an fθ lens.

26. A method for manufacturing a crystalline semiconductor film comprising:

forming an amorphous semiconductor film over a substrate having a refractive index n and a thickness d; and
irradiating the amorphous semiconductor film with a laser beam having a pulse width t that satisfies an inequality ct<4nd where c is a speed of light using an optical system including at least one galvanometer mirror and an fθ lens.

27. A method for manufacturing a crystalline semiconductor film comprising:

forming an amorphous semiconductor film over a substrate; and
irradiating the amorphous semiconductor film with a laser beam in such a way that the laser beam is scanned on the amorphous semiconductor film by at least one galvanometer mirror and an fθ lens,

wherein one point in the amorphous semiconductor film is irradiated simultaneously with both the laser beam incident into the amorphous semiconductor film and the laser beam reflected on a rear surface of the substrate for a time corresponding to 10% or less of a pulse width of the laser beam.

28. A method for manufacturing a crystalline semiconductor film comprising:

forming an amorphous semiconductor film over a substrate having a thickness d and a refractive index n; and
irradiating the amorphous semiconductor film with a laser beam having a pulse width t that satisfies an inequality ct<2nd where c is a speed of light in vacuum,

wherein the laser beam is scanned on the amorphous semiconductor film in a first direction by a first galvanometer mirror,
wherein the laser beam is scanned on the amorphous semiconductor film in a second direction perpendicular to the first direction by a second galvanometer mirror, and
wherein the laser beam forms an image on the amorphous semiconductor film by an fθ lens.

29. A method for manufacturing a crystalline semiconductor film comprising:

forming an amorphous semiconductor film over a substrate having a thickness d and a refractive index n; and
irradiating the amorphous semiconductor film with a laser beam having a pulse width t that satisfies an inequality ct<4nd where c is a speed of light in vacuum,

wherein the laser beam is scanned on the amorphous semiconductor film in a first direction by a first galvanometer mirror,
wherein the laser beam is scanned on the amorphous semiconductor film in a second direction perpendicular to the first direction by a second galvanometer mirror, and
wherein the laser beam forms an image on the amorphous semiconductor film by an fθ lens.

30. A method for manufacturing a crystalline semiconductor film comprising:

forming an amorphous semiconductor film over a substrate; and
irradiating the amorphous semiconductor film with a laser beam in such a way that one point in the amorphous semiconductor film is irradiated simultaneously with both the laser beam incident into the amorphous semiconductor film and the laser beam reflected on a rear surface of the substrate for a time corresponding to 10% or less of a pulse width of the laser beam,

wherein the laser beam is scanned on the amorphous semiconductor film in a first direction by a first galvanometer mirror,
wherein the laser beam is scanned on the amorphous semiconductor film in a second direction perpendicular to the first direction by a second galvanometer mirror, and
wherein the laser beam forms an image on the amorphous semiconductor film by an fθ lens.

31. A method for manufacturing a crystalline semiconductor film comprising:

forming an amorphous semiconductor film over a substrate having a thickness d and a refractive index n; and
irradiating the amorphous semiconductor film with a laser beam having a pulse width t that satisfies an inequality ct<2nd where c is a speed of light in vacuum,

wherein the laser beam is scanned on the amorphous semiconductor film in a first direction by a galvanometer mirror,
wherein the laser beam is scanned on the amorphous semiconductor film in a second direction perpendicular to the first direction by moving a stage with the substrate mounted thereon, and

wherein the laser beam forms an image on the amorphous semiconductor film by an fθ lens.

32. A method for manufacturing a crystalline semiconductor film comprising:

forming an amorphous semiconductor film over a substrate having a thickness d and a refractive index n; and
irradiating the amorphous semiconductor film with a laser beam having a pulse width t that satisfies an inequality ct<4nd where c is a speed of light in vacuum,

wherein the laser beam is scanned on the amorphous semiconductor film in a first direction by a galvanometer mirror,
wherein the laser beam is scanned on the amorphous semiconductor film in a second direction perpendicular to the first direction by moving a stage with the substrate mounted thereon, and
wherein the laser beam forms an image on the amorphous semiconductor film by an fθ lens.

33. A method for manufacturing a crystalline semiconductor film comprising:

forming an amorphous semiconductor film over a substrate; and
irradiating the amorphous semiconductor film with a laser beam in such a way that one point in the amorphous semiconductor film is irradiated simultaneously with both the laser beam incident into the amorphous semiconductor film and the laser beam reflected on a rear surface of the substrate for a time corresponding to 10% or less of a pulse width of the laser beam,

wherein the laser beam is scanned on the amorphous semiconductor film in a first direction by a galvanometer mirror,
wherein the laser beam is scanned on the amorphous semiconductor film in a second direction perpendicular to the first direction by moving a stage with the substrate mounted thereon, and
wherein the laser beam forms an image on the amorphous semiconductor film by an fθ lens.

34. The method for manufacturing a crystalline semiconductor film according to claim 25,
wherein only a necessary part of the semiconductor film or only a part of the semiconductor film where a semiconductor element is formed is irradiated selectively by transmitting the laser beam through a shutter.

35. The method for manufacturing a crystalline semiconductor film according to claim 26,
wherein only a necessary part of the semiconductor film or only a part of the semiconductor film where a semiconductor element is formed is irradiated selectively by transmitting the laser beam through a shutter.

36. The method for manufacturing a crystalline semiconductor film according to claim 27,
wherein only a necessary part of the semiconductor film or only a part of the semiconductor film where a semiconductor element is formed is irradiated selectively by transmitting the laser beam through a shutter.

37. The method for manufacturing a crystalline semiconductor film according to claim 28,
wherein only a necessary part of the semiconductor film or only a part of the semiconductor film where a semiconductor element is formed is irradiated selectively by transmitting the laser beam through a shutter.

38. The method for manufacturing a crystalline semiconductor film according to claim 29,
wherein only a necessary part of the semiconductor film or only a part of the semiconductor film where a semiconductor element is formed is irradiated selectively by transmitting the laser beam through a shutter.

39. The method for manufacturing a crystalline semiconductor film according to claim 30,
wherein only a necessary part of the semiconductor film or only a part of the semiconductor film where a semiconductor element is formed is irradiated selectively by transmitting the laser beam through a shutter.

40. The method for manufacturing a crystalline semiconductor film according to claim 31,
wherein only a necessary part of the semiconductor film or only a part of the semiconductor film where a semiconductor element is formed is irradiated selectively by transmitting the laser beam through a shutter.

41. The method for manufacturing a crystalline semiconductor film according to claim 32,
wherein only a necessary part of the semiconductor film or only a part of the semiconductor film where a semiconductor element is formed is irradiated selectively by transmitting the laser beam through a shutter.

42. The method for manufacturing a crystalline semiconductor film according to claim 33,

wherein only a necessary part of the semiconductor film or only a part of the semiconductor film where a semiconductor element is formed is irradiated selectively by transmitting the laser beam through a shutter.

43. The method for manufacturing a crystalline semiconductor film according to claim 34, wherein the shutter uses an acousto-optic device or an electro-optic device.

44. The method for manufacturing a crystalline semiconductor film according to claim 35, wherein the shutter uses an acousto-optic device or an electro-optic device.

45. The method for manufacturing a crystalline semiconductor film according to claim 36, wherein the shutter uses an acousto-optic device or an electro-optic device.

46. The method for manufacturing a crystalline semiconductor film according to claim 37, wherein the shutter uses an acousto-optic device or an electro-optic device.

47. The method for manufacturing a crystalline semiconductor film according to claim 38, wherein the shutter uses an acousto-optic device or an electro-optic device.

48. The method for manufacturing a crystalline semiconductor film according to claim 39, wherein the shutter uses an acousto-optic device or an electro-optic device.

49. The method for manufacturing a crystalline semiconductor film according to claim 40, wherein the shutter uses an acousto-optic device or an electro-optic device.

50. The method for manufacturing a crystalline semiconductor film according to claim 41, wherein the shutter uses an acousto-optic device or an electro-optic device.

51. The method for manufacturing a crystalline semiconductor film according to claim 42, wherein the shutter uses an acousto-optic device or an electro-optic device.

52. The method for manufacturing a crystalline semiconductor film according to claim 25, wherein the crystalline semiconductor film is applied to an electronic device selected from the group consisting of a camera such as a video camera and a digital camera, a head mounted display, a car navigation, a car stereo, a personal computer and portable information terminal.

53. The method for manufacturing a crystalline semiconductor film according to claim 26, wherein the crystalline semiconductor film is applied to an electronic device selected from the group consisting of a camera such as a video camera and a digital camera, a head mounted display, a car navigation, a car stereo, a personal computer and portable information terminal.

54. The method for manufacturing a crystalline semiconductor film according to claim 27, wherein the crystalline semiconductor film is applied to an electronic device selected from the group consisting of a camera such as a video camera and a digital camera, a head mounted display, a car navigation, a car stereo, a personal computer and portable information terminal.

55. The method for manufacturing a crystalline semiconductor film according to claim 28, wherein the crystalline semiconductor film is applied to an electronic device selected from the group consisting of a camera such as a video camera and a digital camera, a head mounted display, a car navigation, a car stereo, a personal computer and portable information terminal.

56. The method for manufacturing a crystalline semiconductor film according to claim 29, wherein the crystalline semiconductor film is applied to an electronic device selected from the group consisting of a camera such as a video camera and a digital camera, a head mounted display, a car navigation, a car stereo, a personal computer and portable information terminal.

57. The method for manufacturing a crystalline semiconductor film according to claim 30, wherein the crystalline semiconductor film is applied to an electronic device selected from the group consisting of a camera such as a video camera and a digital camera, a head mounted display, a car navigation, a car stereo, a personal computer and portable information terminal.

58. The method for manufacturing a crystalline semiconductor film according to claim 31, wherein the crystalline semiconductor film is applied to an electronic device selected from the group consisting of a camera such as a video camera and a digital camera, a head mounted display, a car navigation, a car stereo, a personal computer and portable information terminal.

59. The method for manufacturing a crystalline semiconductor film according to claim 32,

wherein the crystalline semiconductor film is applied to an electronic device selected from the group consisting of a camera such as a video camera and a digital camera, a head mounted display, a car navigation, a car stereo, a personal computer and portable information terminal.

60. The method for manufacturing a crystalline semiconductor film according to claim 33,

wherein the crystalline semiconductor film is applied to an electronic device selected from the group consisting of a camera such as a video camera and a digital camera, a head mounted display, a car navigation, a car stereo, a personal computer and portable information terminal.

101 102 103 104 105 106 107 108

X1 direction

X2 direction

Y direction

# FIG. 1

FIG. 2

FIG. 3

401 402 403 404 405 406 407 408 409

X1 direction
X2 direction
Y direction

# FIG. 4

801a  802  801b  803  801c  801d  801

800

## FIG. 5A

802a  803a  803b  803e  803c  803c  803d
       802a  802b  802e  802c  802c  802d

806  804  808  810  805  807  809  811

## FIG. 5B

812  813

## FIG. 5C

814  815  816  817  818  819  820  821

## FIG. 5D

TFT for switching | TFT for driving

driver circuit portion | pixel portion

FIG. 6A

FIG. 6B

TFT for switching | TFT for driving

driver circuit portion | pixel portion

EP 1 547 719 A2

FIG. 7A

FIG. 7B

FIG. 7C

FIG. 8A

FIG. 8B

FIG. 8C

FIG. 8D

FIG. 8E

FIG. 8F

FIG. 9A

FIG. 9B

FIG. 9C